Europäisches Patentamt

European Patent Office

Office européen des brevets

(11) Veröffentlichungsnummer: **0 335 838**
**A2**

(12) **EUROPÄISCHE PATENTANMELDUNG**

(21) Anmeldenummer: **89810234.8**

(22) Anmeldetag: **29.03.89**

(51) Int. Cl.⁴: **H 03 K 17/96**

(30) Priorität: **29.03.88 CH 1196/88**

(43) Veröffentlichungstag der Anmeldung:
**04.10.89 Patentblatt 89/40**

(84) Benannte Vertragsstaaten:
**BE CH DE FR GB IT LI NL SE**

(71) Anmelder: **TSCHUDIN & HEID AG**
**Schönmattstrasse 4**
**CH-4153 Reinach (CH)**

(72) Erfinder: **Kaufmann, Josef**
**Innerer Kieslig 388**
**CH-4323 Wallbach (CH)**

(74) Vertreter: **Zbinden, Paul A. et al**
**Patentanwaltsbüro Eder AG Münchensteinerstrasse 2**
**CH-4052 Basel (CH)**

(54) Einrichtung mit einem Träger und mindestens einer ein piezoelektrisches Element aufweisenden, elektrischen Schaltvorrichtung.

㊵ Die Einrichtung (1) weist einen Träger (3) mit einem plattenartigen Teil (11) und mindestens eine lösbar an diesem befestigte, elektrische Schaltvorrichtung (21) mit einem Gehäuse (23) auf. Dieses besitzt an seinem vorderen Ende eine Betätigungswand (23e) und enthält ein piezoelektrisches Element. Das Gehäuse (23) wird bei der Montage der Schaltvorrichtung (21) beispielsweise von der Rückseite des plattenartigen Teils (11) her derart in ein in diesem vorhandenes Loch (11) eingesetzt, beispielsweise eingeschraubt, dass seine Betätigungswand (23e) mindestens ungefähr bündig mit der Vorderseite (11c) des plattenartigen Teils (11) ist. An die Vorderseite (11c) kann eine "Design"-Deck-Folie (13) befestigt sein, welche die Betätigungswand (23e) jeder Schaltvorrichtung (21) bedeckt, und für jede von diesen ein Betätigungs- und/oder Tast-Feld (15) definiert. Schaltvorrichtungen (21) dieser Art können rasch und einfach in verschiedenen Anordnungen und variablen Anzahlen lösbar an entsprechend ausgebildeten Trägern (3) befestigt werden, so dass die Einrichtung auch in kleineren Serien wirtschaftlich herstellbar ist.

Fig. 1

Bundesdruckerei Berlin

## Beschreibung

## Einrichtung mit einem Träger und mindestens einer ein piezoelektrisches Element aufweisenden, elektrischen Schaltvorrichtung

Die Erfindung betrifft eine Einrichtung gemäss dem Oberbegriff des Anspruchs 1.

Die Einrichtung kann als elektrische Steuer- und/oder Schalt-Einrichtung dienen, wobei der Träger mindestens eine ein piezoelektrisches Element aufweisende, elektrische Schaltvorrichtung und in vielen Fällen mehrere solche trägt. Das piezoelektrische Element dient als mechanisch/elektrischer Wandler, um Druckkräfte, die vom sich vor der Träger-Vorderseite befindenden Raum her auf das piezoelektrische Element ausgeübt werden, und/ oder die aus diesen Kräften resultierenden Verformungen in elektrische Signale umzuwandeln. Diese werden dann zur Aufbereitung und/oder sonstigen Verarbeitung elektronischen Schaltungsmitteln zugeführt.

Es sind bereits solche, etwa als Tastaturen dienende Einrichtungen bekannt. Zum Beispiel besitzt eine aus der EP-A-0 210 386 bekannte Tastatur, einen plattenförmigen, mehrschichtigen Träger. Die mittlere Schicht des Trägers ist durch eine Platte mit durchgehenden Löchern gebildet, in denen je ein piezoelektrisches Element angeordnet ist. Die Platte ist beidseitig mit je einer Folie versehen, welche die Löcher beidseitig abdeckt. Ferner können auch noch mit den piezoelektrischen Elementen verbundene, elektronische Schaltungsmittel im Innern des Trägers angeordnet sein. Eine solche Einrichtung, d.h. Tastatur, hat den Nachteil, dass sie nur dann einigermassen wirtschaftlich herstellbar ist, wenn sie in sehr grosser Stückzahl hergestellt wird. Einrichtungen in der Art dieser bekannten Tastatur sind dementsprechend nicht für Anwendungen geeignet, bei denen nur wenige gleich ausgebildete Einrichtungen erforderlich sind oder sogar nur nur eine einzige Einrichtung einer bestimmten Art benötigt wird, wie es zum Beispiel häufig bei Steuer und/oder Schalt-Einrichtungen für in kleinen Serien oder einzeln angefertigte grosse Anlagen, Maschinen und Apparate der Fall sein kann. Ein weiterer Nachteil der bekannten Einrichtung oder Tastatur besteht noch darin, dass es praktisch unmöglich ist, bei einem Defekt ein einzelnes piezoelektrisches Element und die diesem gegebenenfalls zugeordneten sowie im Träger eingebauten elektronischen Schaltungsmittel auszuwechseln, so dass bei einem Defekt jeweils die ganze Tastatur ersetzt werden muss. Zumindest im Fall, dass die mit den piezoelektrischen Elementen verbundenen, elektronischen Schaltungsmittel ebenfalls noch in den Träger eingebaut sind, ist es ferner praktisch nicht möglich, die Schaltfunktion und/oder Schaltleistung der von einem einzelnen piezolelektrischen Element in Zusammenwirkung mit den zugeordneten, elektronischen Schaltungsmitteln gebildeten Schaltvorrichtung nachträglich zu ändern.

Der Erfindung liegt die Aufgabe zugrunde, eine Nachteile der bekannten Einrichtungen behebende Einrichtung zu schaffen, die insbesondere ermöglicht, auch einzeln oder in kleinen Serien hergestellte Einrichtungen wirtschaftlich herzustellen. Ferner soll die bzw. jede ein piezoelektrisches Element aufweisende Schaltvorrichtung vorzugsweise ohne Zerstörung eines tragenden Teils bzw. der tragenden Teile des Trägers und beispielsweise überhaupt ohne Beschädigung des Trägers und auch ohne Beschädigung der Schaltvorrichtung von diesem wegnehmbar sein.

Diese Aufgabe wird durch eine Einrichtung gelöst, die erfindungsgemäss die Merkmale des Anspruchs 1 aufweist.

Die Erfindung betrifft zudem eine elektrische Schaltvorrichtung gemäss dem Anspruch 17.

Vorteilhafte Ausgestaltungen der Einrichtung und Schaltvorrichtung gehen aus den von den Ansprüchen 1 bzw. 17 abhängigen Ansprüchen hervor.

Das Gehäuse weist vorzugsweise einen einstückigen, hülsenförmigen Körper auf, der das piezoelektrische Element enthält und die zum unmittelbaren oder mittelbaren manuellen Drücken bestimmte Betätigungswand sowie auch noch einen sich mindestens teilweise im Loch des Trägers befindenden Mantel bildet. Dieser ist beispielsweise mit einem Aussengewinde versehen und in ein im Loch des Trägers vorhandenes Innengewinde eingeschraubt.

Bei einer vorteilhaften Ausgestaltung des Erfindungsgegenstandes weist das Gehäuse einen von der Rückseite des Trägers her in dessen zugeordnetes Loch hineinragenden Hals und eine an der Rückseite des Trägers unmittelbar oder mittelbar über einen Dichtungs- und/oder Sicherungs- und/ oder Distanzring anliegende Schulter auf. Die Schulter kann durch einen von der Achse des Halses weg über diesen hinausragenden Auflageteil gebildet sein, der vorzugsweise durch einen Kopf mit einer beispielsweise kreiszylindrischen oder im Querschnitt vieleckigen, nämlich etwa sechseckigen Mantelaussenfläche gebildet ist. Die Schulter kann jedoch auch durch eine auf ein Aussengewinde des Gehäuses aufgeschraubte Mutter gebildet und dementsprechend bezüglich des Gehäuses axial verstellbar sein. Wie noch anhand von Ausführungsbeispielen erläutert wird, sind jedoch auch andere Gehäuseformen und Befestigungsarten möglich. Die Innenfläche des Gehäuses ist beispielsweise zumindest im wesentlichen rotationssymmetrisch zur Gehäuseachse.

Der hülsenförmige Körper des Gehäuses kann aus einem metallischen Material oder eventuell einem Kunststoff beste hen, wobei der letztere zweckmässigerweise bis zu einer Temperatur von mindestens 80°C und vorzugsweise mindestens 110°C temperaturfest sein sollte. Ferner kann das piezoelektrische Element an einem Support gehalten sein, der wahlweise in verschiedenarige Gehäuse eingebaut sein kann, deren Materialien, Formen und Abmessungen auf die gewünschte Gehäusefestigkeit und/oder die vorgesehene Befestigungsart und/oder die sonst gestellten Anforderungen abgestimmt sind. Zudem kann das piezoelektrische Element in einem beispielsweise verhältnismässig dünnwandigen und/oder beispielsweise aus Kunststoff bestehenden Gehäuse befestigt sein, das wahlweise direkt im Loch eines Trägers oder im Innern eines anderen, äusseren Gehäuses befestigbar ist, wobei dann das äussere, beispielsweise aus Metall bestehende Gehäuse im Loch eines Trägers befestigt wird. Eine Bauweise, bei welcher das piezoelektrische Element von einem Support oder Gehäuse gehalten ist, der bzw. das wahlweise in verschiedenartige Gehäuse oder direkt in einen Träger einsetzbar ist, ermöglicht Grund-Einheiten mit einem piezoelektrischen Element und einem dieses haltenden Support oder (inneren) Gehäuse in verhältnismässig grosser Stückzahl wirtschaftlich herzustellen und danach für unterschiedliche Befestigungsarten zu ergänzen.

Das bzw. jedes von einem Träger gehaltene Gehäuse enthält ein - und zwar nur ein einziges - zum Umwandeln einer auf die Betätigungswand des Gehäuses einwirkenden Druckkraft in ein elektrisches Signal dienendes, piezoelektrisches Element, das sich hinter der Ebene befindet, die von einem die Schaltvorrichtung umgebenden Bereich des trägers aufgespannt ist. Das piezoelektrische Element weist zum Beispiel ein Plättchen aus dielektrischem, piezoelektrischem, keramischem Material und noch zwei zur Abnahme der erzeugten, elektrischen Signale dienende Signalabnehmer auf. Die letzteren können zum Beispiel elektrisch leitende Elektroden und/oder Anschlüssen aufweisen und beispielsweise mindestens zum Teil durch aufgedampfte, eventuell mindestens teil- und/oder stellenweise gegen aussen elektrisch isolierte Metallschichten gebildet sein. Die Signalabnehmer können bei zwei von einander beabstandeten Stellen, beispielsweise bei zwei entlang dem Plättchen-Umfang gegen einander versetzten, sich etwa gegenüberstehenden Randstellen, oder bei einer Randstelle und einer sich im inneren Bereich einer Plättchen-Fläche befindenden Stelle mit elektrischen Leitern verbunden, die zum Beispiel an den Signalabnehmern des piezoelektrischen Elements angelötet sein können und je einen Draht oder eine aus mehreren Drähten bestehende Litze sowie eventuell einen isolierenden Mantel aufweisen. Man kann jedoch auch einen federnd am piezoelektrischen Element angreifenden Andrück- und/oder Leiter-Körper vorsehen, der eine elektrisch isolierende, beispielsweise gummielastische Matrix sowie in und/oder an dieser angeordnete Leiterbahnen aufweist, welche die an das piezoelektrische Element angeschlossenen Leiter und eventuell sogar noch als Signalabnehmer dienende Elektroden bilden.

Im Innenraum des Gehäuses sind vorzugsweise zusätzlich zum piezoelektrischen Element noch elektrisch mit diesem verbundene, elektronische Schaltungsmittel mit einem elektrisch steuerbaren Schaltorgan angeordnet, um in Zusammenwirkung mit dem piezoelektrischen Element die Funktion eines Drucktasten-Schalters auszuüben. Die Schaltungsmittel können beispielsweise mit mindestens zwei elektrischen Anschlüssen versehen und/oder verbunden sein, die beim Betätigen der Schaltvorrichtung durch das Schaltorgan schaltbar sind, d.h. elektrisch leitend miteinander verbunden oder elektrisch getrennt werden können. Das steuerbare Schaltorgan kann beispielsweise aus mindestens einem Feldeffekt-Transistor und/oder eventuell einem Relais gebildet sein. Die Schaltungsmittel können im übrigen derart ausgestaltet sein, dass die Schaltvorrichtung oder, genauer gesagt, deren steuerbares Schaltorgan den Schaltzustand beim manuellen Betätigen der Schaltvorrichtung, d.h. wenn mit einem Finger eine Druckkraft auf die Betätigungswand und damit auf das piezoelektrische Element ausgeübt wird, nur vorübergehend und kurzzeitig ändert, so dass also die Schaltvorrichtung bei ihrer Betätigung eine an ihre schaltbaren Anschlüsse angelegte Spannung entweder jeweils vorübergehend und kruzzeitig einschaltet oder jeweils kurzzeitig unterbricht und also einen Impuls leifert. Die Schaltvorrichtung führt also in diesem Fall eine Funktion aus, die derjenigen eines Schalters entspricht, der bei mechanisch schaltbare Kontakte aufweisenden Schaltern als Tast-Schalter oder Taster bezeichnet wird. Die elektronischen Schaltungsmittel können statt dessen jedoch auch derart ausgebildet sein, dass die Schaltvorrichtung ihren Schaltzustand beim Betätigen, d.h. beim Ausüben einer Druckkraft auf die Betätigungswand und das piezoelektrische Element, jeweils so lange ändert, bis die Schaltvorrichtung das nächste Mal betätigt wird. Die elektronischen Schaltungsmittel können ferner derart ausgebildet sein, dass die Schaltvorrichtung abhängig von der Dauer oder eventuell Stärke der auf die Betätigungswand ausgeübten Druckkraft als Tast- oder als Rast-Schalter wirkt. Die Schaltvorrichtung kann in diesem Fall zum Beispiel bei kurzem Antippen nur einen Impuls abgeben und beim Drücken während einer vorgegebenen Mindest-Zeitdauer ihren Schaltzustand bleibend, d.h. bis zum nächsten Drücken ändern. Die Schaltvorrichtung führt also in diesem Fall die Funktion eines Schaltertyps aus, der bei Schaltern mit mechanisch schaltbaren Kontakten als Rast-Schalter bezeichnet wird. Die Schaltvorrichtung kann zudem auch drei oder mehr schaltbare Anschlüsse aufweisen und zum Beispiel die Funktion eines Umschalters ausüben oder auch als Mehrfachschalter, d.h. zum Schalten von zwei oder mehr galvanisch getrennten Spannungen dienen, oder als Schrittschalter ausgebildet werden.

Es besteht auch die Möglichkeit, mindestens einen Teil oder alle zusätzlich zum piezoelektrischen Element zur Ausübung einer Schaltfunktion erforderlichen, elektronischen Schaltungsmittel ausserhalb des Gehäuses einer Schaltvorrichtung anzuordnen. In diesem Fall könnten die Elektroden des piezoelektrischen Elements direkt elektrisch leitend mit den aus dem Gehäuse herausgeführten Anschlüssen verbunden sein und/oder diese bilden.

Wenn das Gehäuse mindestens teilweise aus metallischem Material besteht, sind vorzugsweise die Spannungsabnehmer des piezoelektrischen Elements, alle aus dem Gehäuse herausgeführten, elektrischen Anschlüsse sowie alle sonst noch eine elektrische Spannung führenden Teile der im Gehäuse vorhandenen Schaltungsmittel elektrisch gegen das Gehäuse isoliert. Das piezoelektrische Material ist elektrisch isolierend und die Spannungsabnehmer, d.h. Elektroden und/oder Anschlüsse des piezoelektrischen Elements können zum Beispiel derart angeordnet und/oder stellenweise gegen aussen isoliert sein, dass das piezoelektrische Element auf seiner der Betätigungswand des Gehäuses zugewandten Seite elektrisch isolierend ist. Das piezoelektrische Element kann in diesem Fall eventuell und insbesondere wenn die von der Schaltvorrichtung zu schaltenden, elektrischen Spannungen - zwischen verschiedenen Anschlüssen der Schaltvorrichtung sowie gegen Erde gemessen - nur verhältnismässig kleine, vorzugsweise höchstens oder weniger als 50 V und zum Beispiel bis ungefähr 35 V betragende Nennwerte haben, an der metallischen Betätigungswand des Gehäuses direkt, d.h. ohne zusätzliche Isolation, festgeklebt werden, wobei der verwendete Klebstoff vorzugsweise elektrisch isolierend sein soll. Im Bedarfsfall und also vor allem, wenn die Schaltvorrichtung auch zum Schalten von elektrischen Spannungen mit verhältnismässig grossen, beispielsweise 220 V oder mehr betragenden Nennwerten vorgesehen ist, kann zwischen der metallischen Gehäusewandung und dem piezoelektrischen Element selbstverständlich noch eine elektrische Isolation angeordnet werden, die beispielsweise durch ein Stück einer flexiblen Kunststoff-Folie gebildet sein kann, die mit isolierendem Klebstoff auf einer Seite mit der Betätigungswand des Gehäuses und auf der anderen Seite mit dem piezoelektrischen Element verklebt ist. Unter Umständen könnte jedoch einer der Spannungs abnehmer des piezoelektrischen Elements und/oder einer der schaltbaren Anschlüsse elektrisch leitend mit dem metallischen Gehäuse verbunden und/oder durch dieses gebildet sein.

Der vorzugsweise vorhandene, hülsenförmige Körper des Gehäuses ist auf der der Betätigungswand abgewandten Seite des piezoelektrischen Elements vorzugsweise wandlos, d.h. offen. Der bzw. jeder gegen das Gehäuse elektrisch isolierte Anschluss und vorzugsweise überhaupt jeder Anschluss kann dann beim genannten Ende des Gehäuses aus dessen Innenraum herausgeführt sein und beispielsweise einen länglichen, biegbaren, elektrischen Leiter mit einem Draht oder einer aus mehreren Drähten gebildeten Litze, einen elektrisch isolierenden Mantel und möglicherweise an seinem sich ausserhalb des Gehäuses befindenden Ende einen Löt- oder Klemmkontakt aufweisen. Die als Anschlüsse dienenden, flexiblen, isolierten Leiter sind vorzugsweise zwischen ihren im Schaltvorrichtungs-Gehäuse mit den Schaltungsmitteln und/oder dem piezoelektrischen Element der Schaltvorrichtung verbundenen Enden und ihren sich ausserhalb des Schaltvorrichtungs-Gehäuses befindenden Enden mit einer am Gehäuse gehaltenen Zugentlastungsvorrichtung gegen ein Herausreissen aus dem Gehäuse gesichert. Die beim der Betätigungswand abgewandten Ende des Gehäuses vorhandene Öffnung ist vorzugsweise mit einem den restlichen Innenraum des Gehäuses staub-, flüssigkeits- sowie insbesondere wasserdicht und vorteilhafterweise wasserdampf- sowie luft- und/oder sogar vollkommen gasdicht abschliessenden, etwa aus Kunstharz bestehenden Vergussmasse abgeschlossen. Das Gehäuse kann also zumindest in wesentlichen, nämlich abgesehen von der Zugentlastungsvorrichtung und den durch diese und/oder die Vergussmasse gebildeten Verschlussmitteln, ausschliesslich aus dem erwähnten, hülsenförmigen Körper bestehen.

Der Träger einer erfindungsgemässen Einrichtung weist vorzugsweise mindestens einen formfesten, plattenartigen Teil auf, der eine vertikale, geneigte oder horizontale Montage- und/oder Front- und/oder Bedienungswand bildet, an der mindestens eine Schaltvorrichtung befestigt ist. Eine solche Einrichtung kann beispielsweise eine elektrische Steuer- und oder Schalt-Einrichtung, wie eine Schalttafel oder eine Steuer-und/oder Kommandokonsole für irgend eine mindestens teilweise elektrische Anlage oder einen Apparat oder eine Maschine bilden. Bei solchen Einrichtungen sind an einem plattenartigen Teil des Trägers normalerweise mehrere Schaltvorrichtungen montiert. Es kann jedoch auch nur eine einzige Schaltvorrichtung an einem plattenartigen Teil eines Trägers befestigt sein und beispielsweise zum Öffnen der Tür von einem Bahn- oder Tramwagen oder Autobus oder zum Herbeiholen eines Aufzugs dienen. Der plattenartige Teil des Trägers ist normalerweise zumindest im allgemeinen eben und kann lösbar, etwa mit Schrauben, oder unlösbar, etwa mit Nieten oder durch eine Schweiss- oder Klebverbindung, an Teilen eines Gestells und/oder Gehäuses befestigt sein. Der plattenartige Teil kann jedoch auch zusammen mit mindestens einem anderen Teil einen einstückigen Körper bilden und beispielsweise aus einer Wand eines noch andere Wände besitzenden, einstückigen Gehäuses bestehen. Des weitern kann eine Einrichtung und/ oder ihr Träger auch zwei oder mehr je mindestens eine Schaltvorrichtung haltende, plattenartige Teile aufweisen, die in der gleichen Ebene liegen. Die Einrichtung kann ferner zwei oder mehr miteinander einen Winkel bildende, plattenartige Teile, zum Beispiel zur Bildung einer Steuer-Konsole zwei zusammenhängende, durch Abschnitte einer einstückigen, abgewinkelten Platte gebildete, plattenförmige Teile aufweisen, von denen der eine horizontal und der andere geneigt oder vertikal verläuft. Der bzw. jeder plattenartige, mindestens eine Schaltvorrichtung haltende Teil des Trägers weist eine der die Einrichtung bedienenden Person zugewandte Vorderseite und eine Rückseite auf. Der plattenartige Teil ist vorzugsweise für jede an ihm angeordnete, erfindungsgemässe Schaltvorrichtung mit einem kreisförmigen Loch versehen. Dieses ist vorteilhafterweise durchgehend, kann aber eventuell auch als Sarkloch ausgebildet sein. Die Vorderseite der Betätigungswand der bzw. jeder Schaltvorrichtung kann eben sowie mindestens annähernd und vorzugsweise genau mit der von der Vorderseite des plattenartigen Teils aufgespannten Ebene bündig sein, so dass sich die bzw. jede am plattenartigen Teil befestigte Schaltvorrichtung zumindest im wesentlichen oder vollständig hinter der genannten Ebene befindet. Die Betätigungswand kann jedoch stattdessen eine entlang ihrem Rand verlaufende, in axialer Richtung über ihrem mittleren Abschnitt sowie über die Vorderseite des plattenartigen Teils vorstehende, wulstförmige, im Querschnitt beispielsweise verrundete Erhöhung aufweisen, deren Höhe vorteilhafterweise wesentlich kleiner als der Durchmesser des sich im Loch des Trägers befindenden Gehäuseteils ist und beispielsweise höchstens 10 % von diesem beträgt. Die Verbindung zwischen einem plattenartigen Träger-Teil und der bzw. jeder von diesem gehaltenen Schaltvorrichtungs-Gehäuse ist vorteilhafterweise durch den bereits erwähnten Dichtungs- und/oder Sicherungs- und/oder Distanzring und/oder durch andere Dichtungsmittel mindestens staub- und flüssigkeits- sowie insbesondere wasserdicht und beispielsweise auch wasserdampf- und überhaupt gasdicht abgedichtet. Am plattenartigen Teil können möglicherweise zusätzlich zu den erfindungsgemässen Schaltvorrichtungen noch andere Vorrichtungen, zum Beispiel sich in der Nähe der Schaltvorrichtungen befindende sowie zur Anzeige von deren Schaltzustand oder zu sonstigen Zwecken dienende, optische Signalgeber, wie Lämpchen und Leuchtdioden, andere Schalter, kontinuierlich oder stufenweise verstellbare Schaltorgane, digitale oder analoge Anzeigevorrichtungen, Messinstrumente und dergleichen, angeordnet sowie befestigt sein.

Bei einer vorteilhaften Ausgestaltung der Einrichtung ist auf der Vorderseite des formfesten, plattenartigen Teils des Trägers eine im Vergleich zum plattenartigen Teil dünne und flexible "Design"-Deck-Folie befestigt, nämlich aufgeklebt, welche die genannten Löcher, die in diesen eingesetzten Schaltvorrichtungs-Gehäuse sowie zumindest die die Löcher umgebenden Bereiche des plattenartigen Teils und zum Beispiel dessen ganze Vorderseite bedeckt, möglicherweise aber Fenster für Anzeigevorrichtungen, Messinstrumente und dergleichen aufweisen könnte. Die bzw. jede am plattenartigen Teil befestige Schaltvorrichtung und insbesondere auch das Gehäuse der bzw. jeder Schaltvorrichtung befindet sich dann vollständig hinter der die eigentliche Vorderseite des Trägers bildenden, an der Betätigungswand jeder bedeckten Schaltvorrichtung anliegenden Folie. Die "Design"-Deck-Folie kann zum Beispiel aus Kunststoff und/oder Metall und/oder Papier bestehen und soll für jede Schaltvorrichtung eine dieser zugeordnete, optisch und insbesondere visuell erkennbare Markierung aufweisen, die ein zum Beispiel polygon- oder kreisförmiges Betätigungs- und/oder Tast-Feld definiert, das sich vor dem für die betreffende Schaltvorrichtung im plattenartigen Teil vorhandenen Loch befindet, dieses bei zum plattenartigen Teil rechtwinkliger Blickrichtung teilweise oder vollständig bedeckt und/oder mindestens stellenweise über dessen Umriss herausragt. Das bzw. jedes Betätigungs- und/oder Tast-Feld kann beispielsweise durch eine Randlinie und/oder einen Flächenbereich mit einer sich von der Farbe des das Feld umgehenden Flächenbereiches unterscheidenden Farbe definiert sein. Ein Feld kann statt dessen oder vorzugsweise zusätzlich mit einer zur Kennzeichnung der betreffenden Schaltvorrichtung dienenden Bezeichnung, wie einer Zahl und/oder mindestens einem Buchstaben und/oder sonst irgend einem Symbol, bezeichnet sein. Wenn die Betätigungswand der bzw. mindestens einer oder jeder Schaltvorrichtung, wie es vorgängig als Möglichkeit erwähnt wurde, eine entlang ihrem Rand verlaufende Erhöhung besitzt, wird auch die Folie derart verformt, dass sie eine Erhöhung bildet, was ebenfalls zur visuellen Erkennbarmachung des Feldes beiträgt und das letzere zusätzlich durch den Tastsinn einer Bedienungsperson ertast- und spürbar macht. Anstelle der Schaltvorrichtungs-Betätigungswand kann auch die Folie selbst bei dem bzw. mindestens einem oder jedem Betätigungs- und/oder Tast-Feld eine Verdickung aufweisen, die auf der Vorderseite der Folie eine das betreffende Feld umschliessende Erhöhung bildet. Ferner kann das bzw. mindestens ein Tast-Feld auch dadurch den Tastsinn für eine Bedienungsperson spürbar gemacht werden, dass die Oberfläche der Vorderseite der Folie im Bereich des Feldes glatter ist als in dessen Umgebung. Die Folie ist zudem vorzugsweise derart am plattenartigen Teil festgeklebt, dass sie das bzw. jedes von ihr bedeckte Loch mindestens staub- sowie flüssigkeits- und insbesondere wasserdicht und beispielsweise auch wasserdampf-sowie überhaupt gasdicht abschliesst. Die Folie kann zum Definieren der erwähnten Felder und zum Aufbringen von sonst noch vorgesehenen Bezeichnungen je nach dem Material aus dem sie besteht, zum Beispiel bedruckt und/oder anodisch oxydiert oder auf sonst eine Weise markiert werden. Die "Design"-Deck-Folie kann eventuell auch noch stellenweise, zum Beispiel bei sich vor optischen Signalgebern oder Anzeigevorrichtungen befindenden Bereichen lichtdurchlässig oder vollständig durchsichtig sein.

Insbesondere im Fall, dass eine Einrichtung einen Träger besitzt, an dem nur wenige, sich vollständig hinter der Träger-Vorderseite befindende Schaltvorrichtungen befestigt sind oder sogar nur eine einzige solche Schaltvorrichtung befestigt ist, wie es zum Beispiel bei den bereits erwähnten, zum Öffnen einer Tür dienenden Schaltvorrichtungen normalerweise der Fall ist, kann auf eine auch mindestens einen Bereich des plattenartigen Teils bedeckende "Design"-Deck-Folie verzichtet werden. In diesem Fall kann jedoch eventuell auf der Betätigungswand des Gehäuses der bzw. jeder Schaltvorrichtung eine nur gerade diese Betätigungswand bedeckende, mit einer Markierung versehene Folie aufgeklebt oder in anderer Weise befestigt sein. Diese also beispielsweise in der Art einer Klebe- Etikette ausgebildete Folie soll dann vorzugsweise die gleiche Umrissform wie das im Träger vorhandene Loch haben, d.h. gleich wie dieses normalerweise kreisförmig sein, und zudem kleinere Abmessungen als der in die Vorderseite des plattenartigen Teils mündende Abschnitt des Lochs haben sowie vorteilhafterweise mindestens annähernd satt in dieses hineinpassen, so dass sich zwischen der Loch-Innenfläche und dem Rand der Folie höchstens ein im Vergleich zum Loch-Durchmesser schmaler Spalt ergibt.

Weil eine Schaltvorrichtung, abgesehen von der nur sehr geringen, erforderlichen Deformierbarkeit der Betätigungswand und des piezoelektrischen Elements, keine beweglichen Teile aufweist, kann die Schaltvorrichtung ohne weiteres sehr robust und betriebssicher ausgebildet sein, so dass sie auch für einen rauhen Betrieb verwendbar und weitgegend vandalensicher ist. Wenn das bzw. jedes mindestens einen Teil einer Schaltvorrichtung enthaltende Loch eines plattenartigen Teils durch die in vielen Fällen vorhandene "Design"-Deck-Folie dicht abgeschlossen ist und die Verbindung des Schaltvorrichtungs-Gehäuses mit dem plattenartigen Teil des Trägers bei einer bevorzugten Ausführungsform der Einrichtung ebenfalls abgedichtet ist, werden die besagten Löcher doppelt abgedichtet und bleiben auch bei einer allfälligen Beschädigung der "Design"-Deck-Folie noch dicht abgeschlossen. Da der Innenraum des Gehäuses oder bzw. jeder Schaltvorrichtung zudem durch die erwähnte Vergussmasse problemlos dicht gegen die Umgebung der Schaltvorrichtung abgeschlossen sein kann, ist eine erfindungsgemässe Einrichtung auch in staubhaltiger und/oder nasser und/oder explosionsgefährdeter Umgebung verwendbar. Erfindungsgemässe Einrichtungen sind ferner auch gut für Verwendungen geeignet, bei denen die Schaltvorrichtungen einem grossen Personenkreis zugänglich sind, wie es etwa bei Billettautomaten, Türöffnern von Eisenbahn- sowie Tramwagen und Autobussen oder bei Steuer-Einrichtungen von Aufzügen der Fall ist. Erfindungsgemässe Einrichtungen können ferner beispielsweise ohne weiteres auch in Kies- und Betonwerken, Giessereien, bei Tanksäulen und in Chemieanlagen eingesetzt werden.

Die Ausbildung des Trägers, die Anzahl sowie Anordnung der an diesem befestigten Schaltvorrichtungen und die Gestaltung der allenfalls vorhandenen "Design"-Deck-Folie können nach Belieben variiert werden. Man kann die Schaltvorrichtungen in grossen Serien verhältnismässig kostengünstig herstellen und die Schaltvorrichtungen dann an Einrichtungen mit unterschiedlich ausgebildeten Trägern montieren, was auch bei der Verwendung für einzelne oder nur in kleinen Serien hergestellten Einrichtungen eine wirtschaftliche Herstellung der Träger und eine wirtschaftlichen Montage der Schaltvorrichtungen an den Trägern ermöglicht.

Ferner erlaubt die vorzugsweise vorgesehene, lösbare Befestigung der Schaltvorrichtungen, eine bereits an einen Träger montierte Schaltvorrichtung im Fall eines Defekts oder zum Ersetzen durch eine zu einem anderen Typ gehörende Schaltvorrichtung, die beispielsweise das Schalten einer grösseren Spannung oder eines grösseren Stroms erlaubt oder eine andere Schalt-Funktion ergibt, rasch und mühelos zu demontieren, vom Träger zu trennen und zu ersetzen. Wenn der Träger mit einer "Design"-Deck-Folie versehen und die Vorderseite der bzw. jeder von der Folie bedeckten Betätigungswand vollständig eben und mit der Vorderseite des plattenartigen Teils bündig ist, kann die Folie entweder an der Betätigungswand festgeklebt sein oder lediglich frei an dieser anliegen, wobei letzteres den Vorteil ergibt, dass eine Schaltvorrichtung problemlos ohne Beschädigungsgefahr der Folie vom Träger trennbar ist. Wenn eine von einer Folie bedeckte Betätigungswand eine entlang von ihrem Rand verlaufende Erhöhung besitzt, sollte die Folie an der Betätigungswand ebenfalls angeklebt werden, damit sie auch im von der Erhöhung umschlossenen, eine Vertiefung bildenden Bereich der Betätigungswand an dieser anliegt.

Die Erfindung wird nun anhand in der Zeichnung dargestellter Ausführungsbeispiele erläutert. In der Zeichnung zeigt

die Figur 1 eine Schrägansicht einer Einrichtung mit einem einen plattenartigen Teil sowie eine "Design"-Deck-Folie aufweisenden Träger zum Halten von Schaltvorrichtungen, wobei die "Design"-Deck-Folie in teilweise von der Platte abgelöstem Zustand und eine Schaltvorrichtung in vom Träger getrenntem Zustand gezeichnet ist,

die Figur 2 eine Seitenansicht einer Schaltvorrichtung, in grösserem Massstab,

die Figur 3 einen schematisierten Schnitt durch einen Bereich des Trägers und eine Schaltvorrichtung, im gleichen Massstab wie die Figur 2,

die Figur 4 eine Draufsicht auf die separat gezeichnete Zugentlastungsvorrichtung mit Blickrichtung von der Betätigungswand her,

die Figur 5 einen Ausschnitt einer Variante einer Einrichtung, deren Träger einen plattenartigen Teil mit einer Ausstülpung aufweist, wobei der Träger im Schnitt und die Schaltvorrichtung getrennt von diesem in Ansicht gezeichnet ist,

die Figur 6 eine der vorangehenden Figur entsprechende Darstellung eines Ausschnitts einer anderen Variante der Einrichtung, deren plattenartiger Teil beim Loch mit einem Ring versehen ist,

die Figur 7 eine perspektivische Ansicht einer Einrichtung, mit teilweise unterschiedlich grossen Betätigungs- und/oder Tast-Feldern,

die Figur 8 einen Schnitt durch den Träger einer Einrichtung mit einer teils in Ansicht teils im Schnitt gezeichneten Schaltvorrichtung, deren Betätigungswand eine entlang ihrem Rand verlaufende Erhöhung besitzt,

die Figur 9 eine Draufsicht auf die Betätigungswand der separat gezeichneten Schaltvorrichtung der in der Figur 8 ersichtlichen Einrichtung,

die Figur 10 einen Schnitt durch den Träger einer Einrichtung mit einer durch Einpressen in ein Loch des plattenartigen Träger-Teils befestigten Schaltvorrichtung,

die Figur 11 einen Schnitt durch den Träger einer Einrichtung mit einer im Loch des plattenartigen Träger-Teils festgeklebten Schaltvorrichtung,

die Figur 12 eine teils im Schnitt und teils in Ansicht gezeichnete Einrichtung, deren Schaltvorrichtung einen Bund mit Löchern besitzt und mit diese durchdringenden Schrauben befestigt ist,

die Figur 13 eine Einrichtung, deren Schaltvorrichtung mit einem bügelförmigen Halter und Schrauben befestigt ist,

die Figur 14 eine Einrichtung, bei welcher eine Schaltvorrichtung mit Schrauben und einer als Halter dienenden Platte einer gedruckten Schaltung am Träger befestigt ist,

die Figur 15 einen Schnitt durch einen Bereich eines Trägers, in dessen plattenartigem Teil eine Schaltvorrichtung eingeschraubt und mit einer Mutter gesichert ist,

die Figur 16 einen schematisierten Schnitt durch die in der Figur 15 gezeichnete Schaltvorrichtung,

die Figur 17 einen Schnitt durch einen Träger und das äussere Gehäuse einer Schaltvorrichtung, das auf einer in einem Loch des Trägers vorhandenen Auflagefläche aufliegt,

die Figur 18 einen Schnitt durch einen Träger einer Steuer-und/oder Schalt-Einrichtung, deren Schaltvorrichtung ein Gehäuse mit Rast-Vorsprüngen aufweist, die eine Rast-Erweiterung eines im plattenartigen Teil des Trägers vorhandenen Lochs hintergreifen,

die Figur 19 einen Schnitt durch den Träger einer Einrichtung mit einer Schaltvorrichtung, deren Gehäuse in axialer Richtung gegeneinander versetzte Klemm-Vorsprünge aufweist, die an der zylindrischen Begrenzungsfläche eines Lochs des plattenartigen Teils des Trägers angreifen,

die Figur 20 eine Einrichtung mit einer Schaltvorrichtung, deren Gehäuse einen Rast-Vorsprung aufweist, der in eine in einem Loch des Trägers vorhandene Rast-Rille eingreift,

die Figur 21 einen Schnitt durch einen Träger, dessen plattenartiger Teil ein Sackloch aufweist, in dem eine Schaltvorrichtung befestigt ist,

die Figur 22 eine Einrichtung deren Schaltvorrichtungen in durchgehend offene Löcher eines Trägers eingesetzt sind,

die Figur 23 ein Blockschema einer ohne Hilfsspannungen arbeitenden Schaltvorrichtung,

die Figur 24 ein Blockschema einer Schaltvorrichtung mit zwei hintereinander geschalteten, elektronischen Schaltorganen und

die Figur 25 ein Blockschema einer Schaltvorrichtung, die zusätzlich zu den durch ein Schaltorgan schaltbaren Anschlüssen noch Anschlüsse zum Zuführen einer Hilfs- und/oder Betriebsspannung aufweist.

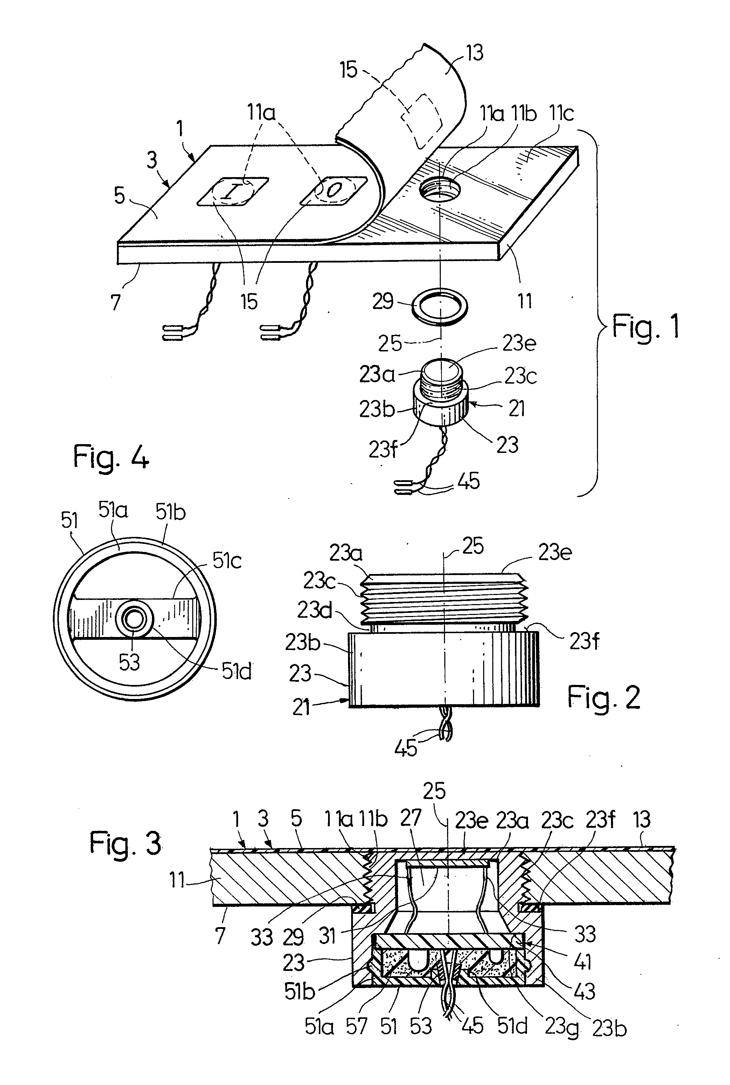

Die in der Figur 1 ersichtliche, als Ganzes mit 1 bezeichnete, elektrische Steuer- und/oder Schalt-Einrichtung besitzt einen plattenartigen Träger 3 mit einer Vorderseite 5 sowie einer Rückseite 7, wobei die beiden Seiten 5, 7 eben sind und also je eine Ebene aufspannen. Der Träger 3 dient als Montage-und/oder Front- und/oder Bedienungswand und ist derart vertikal, geneigt oder horizontal mit einem nicht dargestellten Gestell und/oder mit anderen Wandungsteilen eines Gehäuses verbunden, dass seine Vorderseite 5 für eine die Einrichtung bedienende Person gut zugänglich ist. Der Träger 3 weist einen formfesten, ebenen, plattenartigen Teil 11, nämlich eine metallische Montageplatte mit einer Anzahl durchgehender Löcher 11a auf, wobei als Beispiel drei Löcher gezeichnet sind. Jedes Loch 11a hat einen kreisförmigen Umriss sowie ein Innengewinde 11b und bildet also eine Gewindebohrung. Auf der eine Ebene aufspannenden Vorderseite 11c, d.h. vorderen Begrenzungsfläche, des plattenartigen Teils 11 ist eine flexible, zum Beispiel aus Kunststoff bestehende "Design"-Deck-Folie 13 befestigt, nämlich wasserdicht sowie beispielsweise auch wasserdampfdicht aufgeklebt, welche die ganze Vorderseite des plattenartigen Teils 11 und also insbesondere auch die im letzteren vorhandenen Löcher 11a bedeckt. Die dem plattenartigen Teil 11 abgewandte, vordere Begrenzungsfläche der Folie 13 bildet die bereits erwähnte Vorderseite 5 des Trägers 3, während dessen Rückseite 7 durch die hintere Begrenzungsfläche des plattenartigen Teils gebildet ist. Die Folie 13 ist auf ihrer Vorderseite mit Markierungen bedruckt, die vor jedem Loch 11a ein Betätigungs- und/oder Tast-Feld 15 definieren, das beispielsweise einen viereckigen Umriss hat und dessen Zentrum auf der Achse des betreffenden Lochs liegt. Die einzelnen Felder 15 sind durch eine sie umschliessende Randlinie und/oder durch eine sich von der Farbe des sie umgebenden Folienbereichs unterscheidende Farbe optisch und vi suell erkennbar gemacht und zudem durch verschiedene Buchstaben, Wörter, Zahlen und/oder sonstige Symbole bezeichnet.

Am plattenartigen Teil 11 ist bei jedem Loch 11a eine besonders deutlich in den Figuren 2 und 3 ersichtliche, elektrische Schaltvorrichtung 21 lösbar befestigt. Jede Schaltvorrichtung 21 besitzt ein Gehäuse 23, das zum Beispiel aus einem metallischen, nämlich aus Aluminium oder rostfreiem Stahl bestehenden, einstückigen, hülsenförmigen Körper mit schraubenartiger Umrissform gebildet ist und einen im allgemeinen zylindrischen Hals 23a, einen zylindrischen Kopf 23b und ein mit der Achse des betreffenden Lochs zusammenfallende Achse 25 besitzt. Die Aussenfläche des Mantels des Halses 23a ist mit einem Aussengewinde 23c und zwischen diesem und dem Kopf mit einer durch eine Ringnut gebildeten Hinterschneidung 23d versehen. Der Innenraum 27 des Gehäuses 23 ist am halsseitigen Ende durch eine mit dem Mantel des Gehäuses zusammenhängende Betätigungswand 23e abgeschlossen. Von dieser ist mindestens der mittlere, die Achse 25 enthaltende und kreuzende Abschnitt auf der äussern, vordern Seite sowie auf der innern, hintern Seite je durch eine ebene, zur Achse 25 rechtwinklige Fläche begrenzt. Die äussere, vordere dieser beiden ebenen Flächen erstreckt sich zumindest im wesentlichen, nämlich abgesehen von einem schmalen, konisch angeschrägten Randbereich des Halses, über dessen ganzen Aussendurchmesser. Das Gehäuse 23 und alle übrigen Teile der Schaltvorrichtung 21 befinden sich vollständig hinter der von der vorderen Fläche der Betätigungswand aufgespannten Ebene. Der Kopf 23b ragt von der Achse 25 weg über den Hals 23a hinaus und bildet an seinem mit dem Hals zusammenhängenden Ende eine Schulter 23f mit einer Gehäuse den Hals ringförmig umschliessenden, radialen, zur Achse 25 rechtwinkligen Auflagefläche. Das Gehäuse 23 ist am kopfseitigen Ende offen, d.h. wandlos. Der Innenraum 27 des Gehäuses 23 hat an seinem kopfseitigen Ende eine im allgemeinen zylindrische Erweiterung, bei deren sich näher bei der Betätigungswand be findendem Ende von der Innenfläche des Gehäuses eine ringförmige, radiale Auflagefläche 23g gebildet wird. Die Aussenfläche sowie die Innenfläche des Gehäuse 23 sind also im allgemeinen, d.h. abgesehen vom Aussengewinde 23c, rotationssymmetrisch zur Achse 25.

Ein Dichtungs- und/oder Sicherungs- und/oder Distanzring 29, der beispielsweise aus einem gummielastischen Material besteht, wird bei der Montage unter einer vorübergehenden elastischen Aufweitung über das Aussengewinde 23c des Halses 23b geschoben und ragt dann mit seinem Innenrand in die Hinterschneidung 23d hinein. Wenn eine Schaltvorrichtung 21 sich in ihrem am Träger 3 befestigten, in der Figur 3 dargestellten Zustand befindet, ist das Aussengewinde 23c ihres Halses 23b mit dem Innengewinde 11b des zugeordneten Lochs 11a des plattenartigen Teils 11 verschraubt. Der Kopf 23b liegt dann mit der Auflagefläche seiner Schulter 23f am Ring 29 an, der seinerseits an der Rückseite des plattenartigen Teils 11 anliegt. Der Kopf 23b oder, genauer gesagt, dessen radial über den Hals 23a hinausragender Abschnitt bildet also einen mittelbar über den Ring 29 an der Rückseite 7 des Trägers 3 anliegegenden Auflageteil oder Anschlag. Der Ring 29 dichtet das Gehäuse 23 mindestens wasserdicht und beispielsweise auch noch wasserdampfdicht sowie überhaupt vollkommen gasdicht gegen den plattenartigen Teil 11 ab. Die Dicke des plattenartigen Teils 11, die parallel zur Achse 25 gemessene Abmessung des Halses 23a und die in der gleichen Richtung gemessene Dicke des Rings 29 sind derart aufeinander abgestimmt, dass sich der Hals 23a von der Rückseite des plattenartigen Teils 11 her bis mindestens annähernd und möglichst genau zu dessen Vorderseite 11c erstreckt, so dass die letztere und die Vorderseite der Gehäuse-Betätigungswand 23e mindestens ungefähr und vorzugsweise genau bündig sind, d.h. in der gleichen Ebene liegen. Die Folie 13 liegt dementsprechend auch an der Betätigungswand 23e an. Der Dichtungs-, Sicherungs- und/oder Distanzring 29 ist in axialer Richtung - ausgehend von seiner axialen Abmessung im unbelasteten Zustand - durch den Kopf 23b mindestens 0,1 mm und beispielsweise mindestens etwa 0,2 mm oder sogar mindestens oder ungefähr 0,3 mm zusammendrückbar, so dass durch Fabrikationsungenauigkeiten verursachte Abweichungen der Dicke des plattenartigen Teils 11 sowie der axialen Abmessungen des Halses 23a und des Rings 29 durch unterschiedlich starkes Zusammendrücken des letzteren ausgeglichen werden können und das Gehäuse 23 dadurch bei seiner Befestigung am Träger in eine Lage bringbar ist, in der die Vorderseite der Betätigungswand 23e auch beim Vorhandensein von Fabrikationsungenauigkeiten möglichst genau bündig mit der Vorderseite 11c des plattenartigen Teils 11 ist.

Ein plättchenförmiges, piezoelektrisches Element 31 weist ein Plättchen aus piezoelektrischer Keramik und zwei Signalabnehmer auf. Das piezoelektrische Element ist im Innenraum 27 des Gehäuses 23 angeordnet und mit dessen Betätigungswand 23e verbunden, nämlich beispielsweise bei einer seiner beiden Flächen oder, genauer gesagt, Breitflächen mit einer dünnen, flexiblen, nicht gezeichneten Schicht aus elektrisch isolierendem Klebstoff unmittelbar am ebenen Bereich der Innenfläche der Betätigungswand 23e angeklebt, wobei nötigenfalls zwischen der Betätigungswand und dem piezoelektrischen Element noch eine aus einem flexiblen Folienstück bestehende, elektrische Isolation angeordnet werden kann. Die Folie 13 und die Betätigungswand 23e sind derart ausgebildet und bemessen, dass einerseits bereits eine relativ kleine, mit einem Finger in einem Feld 15 auf die Aussenfläche der Folie ausgeübte Druckkraft auf das piezoelektrische Element übertragen wird und zur Betätigung der Schaltvorrichtung ausreicht, die Folie und Betätigungswand aber andererseits verhältnismässig robust sind, so dass sie beispielsweise durch einen Druck mit einem scharfen Fingernagel nicht beschädigt werden. Das piezoelektrische Element 31 hat beispielsweise eine viereckige, etwa rechteckige Umrissform, könnte aber auch kreisförmig sein oder sonst irgend eine Form haben. Die Signalabnehmer des piezoelektrischen Elements 31 sind zum Beispiel bei und/oder in der Nähe von zwei entlang dem Umfang des Elements gegeneinander versetzten, etwa bei sich gegenüberstehenden Viereckseiten angeordneten Randabschnitten des Elements 31 mit elektrischen, biegbaren Leitern 33 verbunden, die beispielsweise an den Signalabnehmern des Elements 31 angelötet sind und je mindestens einen biegbaren Draht aufweisen. Die Verbindungsstellen der Leiter 33 mit den Signalabnehmern befinden sich beispielsweise auf der der Betätigungswand 23e abgewandten Seite bzw. Fläche des piezoelektrischen Elements 31. Im Gehäuse-Innenraum 27 angeordnete, elektronische Schaltungsmittel 41 weisen eine gedruckte Schaltung mit einem aus Isoliermaterial bestehenden, mindestens auf einer Seite mit Leiterbahnen bedruckten und elektronische Komponenten tragenden Plättchen 43 auf, das auf der Auflagefläche 23g aufliegt. Die gedruckte Schaltung ist einerseits mit den die beiden Elektroden 33 bildenden Leitern und andererseits mit mindestens zwei Anschlüssen 45 verbunden, die je einen beim kopfseitigen Ende des Gehäuses aus dessen Innenraum 27 herausgeführten, biegbaren, elektrischen Leiter mit mindestens einem Draht und einem elektrisch isolierenden Mantel aufweisen und an ihren sich ausserhalb des Gehäuses befindenden Enden eventuell mit einem Löt- oder Klemmkontakt oder dergleichen versehen sind. Eine Zugentlastungsvorrichtung 51 weist als Hauptbestandteil einen Ring 51a, auf, der mit einer zylindrischen Aussenfläche an der zylindrischen Innenfläche der Erweiterung des Gehäuses 23 anliegt und mit einer ringförmigen Rastrippe 51b in eine Ringnut der Gehäuse-Innenfläche eingerastet ist. Ein Steg 51c verbindet zwei sich diametral gegenüberstehende Stellen des Rings 51a und hält eine Klemmhülse 51d mit einem zur Achse 25c parallelen und beispielsweise koaxialen Durchgangsloch. Der Ring 51a, der Steg 51c und die Klemmhülse 51d bestehen zum Beispiel aus einem einstückigen Kunststoffkörper. Die Leiter 45 sind zwischen ihren im Innenraum des Gehäuses 23 mit den elektronischen Schaltungsmitteln 43 und/oder dem piezoelektrischen Element 31 verbundenen Enden und ihren sich ausserhalb des Gehäuses 23 befindenden Enden durch die Klemmhülse 51d hindurchgeführt und in dieser mit einem ringförmigen, beispielsweise gummielastischen Klemmelement 53 festgeklemmt und gegen ein Herausreissen aus dem Gehäuse sowie Wegreissen von den Schaltungsmitteln 41 gesichert. Der Ring 51a greift zudem am Plättchen 43 der gedruckten Schaltung an und hält dieses im Gehäuse 23 fest. Zudem kann der Steg noch einen als Datenträger dienenden, nicht dargestellten Lappen halten, der mindestens eine visuell lesbare, für die Schaltvorrichtung charakteristische Angabe, wie die maximal zulässige Spannung und/oder den maximal zulässigen Strom und/oder eine Typenbezeichnung trägt. Der zwischen der gedruckten Schaltung und dem der Betätigungswand 23e abgewandten Ende des Kopfs 23b vorhandene Bereich des Innenraumes 27 ist mindestens zum Teil mit einer elektrisch isolierenden Vergussmasse 47 gefüllt, welche bei der Herstellung der Schaltvorrichtung durch die beidseitig vom Steg 51c vorhandenen Öffnungen der Zugentlastungsvorrichtung 51 hindurch in den Gehäuse-Innenraum eingebracht werden kann und dessen die gedruckte Schaltung sowie das piezoelektrische Element enthaltenden Bereich zusammen mit der Zugentlastungsvorrichtung 1251 gegen die Umgebung dicht abschliesst sowie zudem zur Befestigung des Plättchens 43 beiträgt.

Falls eine Schaltvorrichtung 21 vom Träger getrennt werden soll, kann sie selbstverständlich aus dem betreffenden Loch 11a des plattenartigen Teils herausgeschraubt werden, ohne diesen zu beschädigen. Zumindest im Fall, dass die Folie 13 an der Betätigungswand 23e nicht festgeklebt oder die Klebverbindung zwischen der Folie und der Betätigungswand lösbar ist, wird bei der Demontage weder die Folie noch die Schaltvorrichtung beschädigt.

Die Einrichtung 101, von der in der Figur 4 ein Ausschnitt dargestellt ist, hat einen Träger 103 mit einer Vorderseite 105 sowie einer Rückseite 107. Der Träger 103 weist einen metallischen plattenartigen Teil 111 auf, der Löcher 111a mit Innengewinden 111b besitzt. Da der plattenartige Teil 111 im Vergleich zum plattenartigen Teil 11 eine verhältnismässig geringe Dicke hat, ist er bei jedem Loch 111a mit einer dieses umschliessenden, zum rückseitigen, d.h. der Träger-Vorderseite 105 abgewandten Raumbereich hinragenden Verdickung 111d versehen, die durch eine mit dem restlichen plattenartigen Teil 111 zusammen aus einem einstückigen Körper bestehende, durch eine plastische Verformung erzeugte Ausstülpung gebildet ist. Auf der Vorderseite 111c des plattenartigen Teils 111 ist eine "Design"-Deck-Folie 113 aufgeklebt. In jedem Loch 111a ist der Gehäuse-Hals einer elektrischen Schaltvorrichtung 121 eingeschraubt, die gleich oder ähnlich wie die Schaltvorrichtung 21 ausgebildet ist und insbesondere ein gleich wie bei dieser ausgebildetes Gehäuse besitzt.

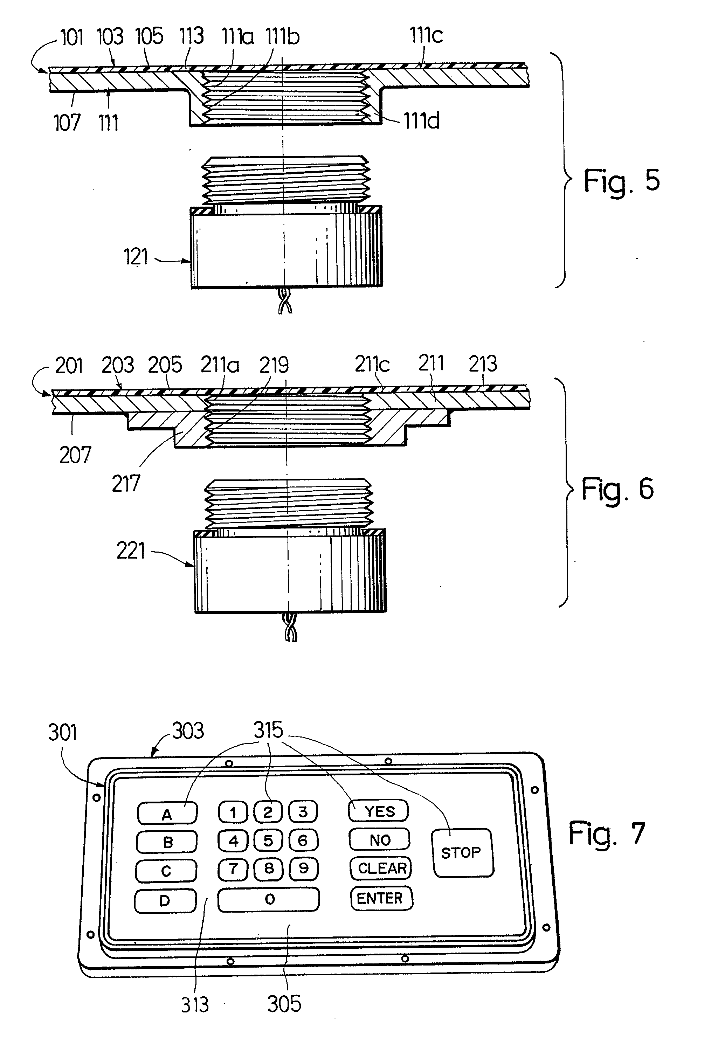

Die in der Figur 5 gezeichnete Einrichtung 201 besitzt einen Träger 203 mit einer Vorderseite 205 und einer Rückseite 207. Der Träger 203 weist einen plattenartigen Teil 211 mit Löchern 211a auf. An der Rückseite des Teils 211 ist bei jedem Loch 211a zur Verstärkung ein eine Verdickung 217 bildender Ring 217 befestigt, etwa festgeklebt oder festgeschweisst. Das Loch 211a und das Loch des Rings sind mit einem als Ganzes mit 219 bezeichneten Innengewinde versehen. Auf der Vorderseite 211c des plattenartigen Teils 211 ist eine "Design"-Deck-Folie 213 festgeklebt und in jeder vom plattenartigen Teil 211 sowie einem Ring 217 begrenzten Gewindebohrung ist eine gleich oder ähnlich wie die Schaltvorrichtungen 21 ausgebildete, elektrische Schaltvorrichtung 211 lösbar eingeschraubt.

Die in der Figur 6 ersichtliche Einrichtung 301 besitzt einen Träger 303 mit einem plattenartigen Teil und einer auf diesen aufgeklebten "Design"-Deck-Folie 313, deren Vorderseite 305 die Vorderseite des Trägers 303 bildet. Der plattenartige Teil ist fest mit einem beispielsweise mit ihm zusammen aus einem einstückigen Körper bestehenden Rahmen verbunden, dessen vordere Begrenzungsfläche sich ein wenig hinter der Vorder seite 305 befindet und Befestigungslöcher besitzt. Die Folie 313 ist mit Markierungen versehen, die Betätigungs- und/oder Tast-Felder 315 mit verschiedenen Grössen und Umrissformen definieren und durch verschiedene Bezeichnungen, nämlich je einen einzelnen Buchstaben, eine Zahl oder ein Wort, gekennzeichnet sind. Jedem Feld 315 ist eine Schaltvorrichtung zugeordnet, deren Gehäuse gleich wie dasjenige der Schaltvorrichtungen 21 ausgebildet ist. Die verschiedenen Schaltvorrichtungen können beispielsweise alle in der Art eines Tastschalters oder alle in der Art eines Rastschalters oder teils in der einen und teils in der anderen dieser beiden Schalterarten ausgebildet sein.

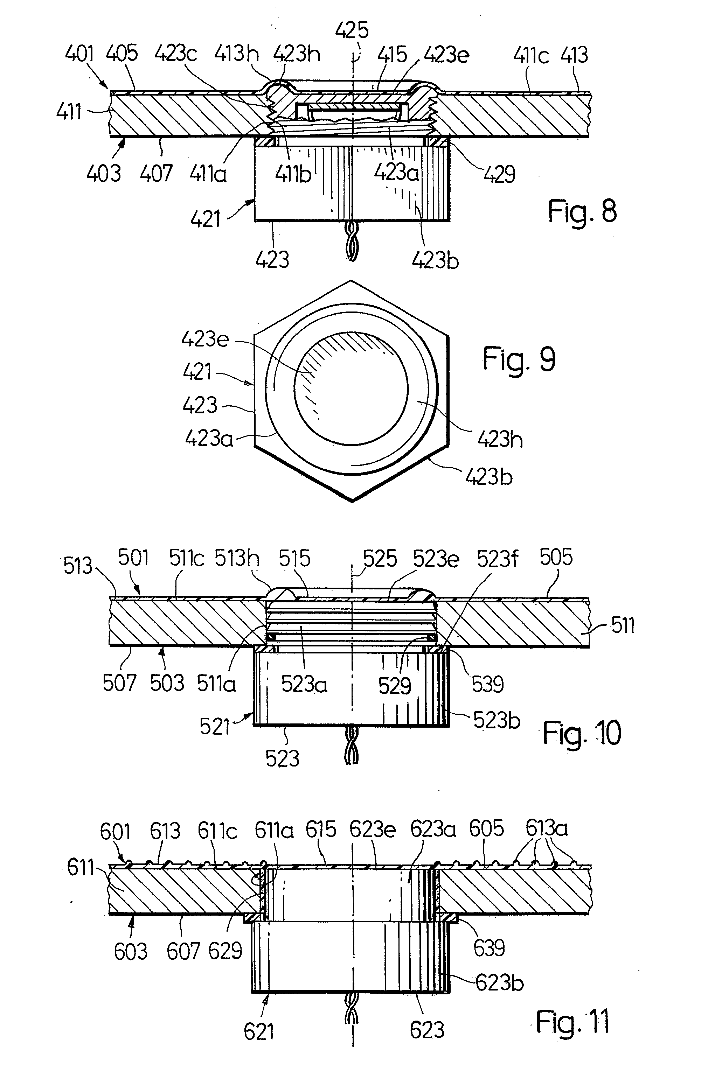

Die in der Figur 8 ersichtliche Einrichtung 401 besitzt einen Träger 403 mit einer Vorderseite 405 sowie einer Rückseite 407. Der plattenartige Teil 411 des Trägers hat mindestens ein Loch 411a mit einem Innengewinde 411b und eine ebene Vorderseite 411c, auf die eine die Träger-Vorderseite bildende "Design"-Deck-Folie 413 aufgeklebt ist. Eine noch separat in der Figur 9 gezeichnete, elektrische Schaltvorrichtung 421 weist ein Gehäuse 423 mit einem Hals 423a und einem Kopf 423b auf. Der Hals ist bei der Aussenfläche seines Mantels mit einem Aussengewinde 423a versehen und derart in das Loch 411a eingeschraubt, dass die vom Kopf gebildete Schulter analog wie bei der Schaltvorrichtung 21 über einen Dichtungs- und/oder Sicherungs- und/oder Distanzring 429 an der Rückseite des Trägers 403 anliegt. Das Gehäuse 423 unterscheidet sich aber vom Gehäuse 23 dadurch, dass die Aussenfläche seiner Betätigungswand 423e nur im mittleren, die Gehäuse-Achse 425 kreuzenden Bereich eben ist und mindestens ungefähr in der von der Vorderseite 411c des plattenartigen Teils 411 augespannten Ebene liegt, beim Rand der Betätigungswand jedoch eine entlang von diesem verlaufende, wulstförmige, in einem durch die Achse 425 gelegten Schnitt verrundete, Erhöhung 423h besitzt. Diese ragt in axialer Richtung über den mittleren Abschnitt der Betätigungswand 423e sowie die Vorder seite 411c des plattenartigen Teils 411 hinaus und bewirkt dadurch auch eine Verformung sowie Ausbuchtung der auch an der Betätigungswand anliegenden Folie 413, so dass diese beim Rand der Betätigungswand 423e ihrerseits eine Erhöhung 413h bildet. Die Folie soll bei einer solchen Ausbildung der Betätigungswand an dieser angeklebt sein, damit sie auch im mittleren, von der Erhöhung 423h umschlossenenen, gegenüber dieser eine Vertiefung bildenden Bereich der Betätigungswand 423e an dieser anliegt. Die parallel zur Achse 25 gemessenen Höhen der Erhöhungen 413h sowie 423h betragen beispielsweise etwa 1 bis 10 % des Aussendurchmessers der Betätigungswand. Die Erhöhung 413h kann zusammen mit einer allfälligen Bedruckung der Folie oder für sich allein ein für eine die Schaltvorrichtung betätigende Bedienungsperson visuell ersehbares und zusätzlich mit dem Tastsinn erspürbares Betätigungs- und/oder Tast-Feld 415 begrenzen. Das Gehäuse 423 unterscheidet sich vom Gehäuse 23 auch noch dadurch, dass sein Kopf 423b eine vieleckige, nämlich sechseckige, das Angreifen mit einem Schlüssel ermöglichende Umrissform hat, wie es besonders deutlich aus der Figur 9 ersichtlich ist.

Zur in der Figur 10 dargestellten Einrichtung 501 gehört ein Träger 503 mit einem plattenartigen Teil 511, der ein durchgehendes, durch eine glatte Zylinderfläche begrenztes Loch 511a aufweist und auf dessen Vorderseite 511c eine "Design"-Deck-Folie 513 aufgeklebt ist, deren Vorderseite die Vorderseite 505 des Trägers bildet. Eine elektrische Schaltvorrichtung 521 besitzt ein Gehäuse 523 mit einem Hals 523a sowie einem Kopf 523b, wobei mindestens der Hals des Gehäuses zu einer Achse 525 rotationssymmetrisch ist. Der Hals ist von der Rückseite 507 des Trägers 511 her derart in das Loch 511a eingepresst, dass er in diesem festsitzt und also die Aussenfläche von mindestens einem Teilabschnitt des Mantels des Halses mit der Begrenzungsfläche des Lochs 511a zusammen eine Press-Verbindung, d.h. einen Press-Sitz bildet. Die zur Bildung der Press-Verbindung dienende Aussenfläche des Halses 523a kann durch eine glatte Zylinderfläche gebildet sein oder - wie in der Figur 10 gezeichnet - einige durch ringförmige Rillen getrennte, ringförmige Rippen aufweisen, wobei die vorderen Rippenflanken beispielsweise weniger stark gegen die Achse 525 geneigt sind als die hinteren Rippenflanken. Die durch das Einpressen erstellte, feste Verbindung der Schaltvorrichtung 521 mit dem Träger 511 soll vorzugsweise lösbar sein, so dass die Schaltvorrichtung 521 wieder aus dem Loch 511 herausgezogen und/oder herausgedrückt und vom Träger 503 getrennt werden kann, ohne den plattenartigen Teil 511 sowie wenn möglich auch ohne die Folie 513 und also überhaupt ohne den Träger 503 sowie wenn möglich auch ohne die Schaltvorrichtung 521 zu beschädigen.

Die Vorderseite der Betätigungswand 523e ist bei diesem Ausführungsbeispiel vollständig eben. Hingegen ist die Folie 513 in der Nähe der Ränder des Lochs 511a und der Betätigungswand 523e mit einer beispielsweise entlang diesen Rändern um die Achse 525 herum verlaufenden Verdickung versehen, die eine auf ihrer Vorderseite vorstehende, wulstförmige Erhöhung 513h bildet und ein Betätigungs- und/oder Tast-Feld 525 umschliesst.

Der sich im Innern des Lochs 511a befindende Teil des Halses 523a ist zum Beispiel in der Nähe der Rückseite 507 des Trägers 503 mit einer Ringnut versehen, in der ein gummielastischer Dichtungsring 529 eingesetzt ist, der den Hals gegen den plattenartigen Teil 511 abdichtet. Zwischen der Rückseite 507 des Trägers 503 und der vom Kopf 523b gebildeten Schulter 523f ist ein Distanzring 529 vorhanden, der beispielsweise aus einem verhältnismässig harten, d.h. nicht gummielastischen und nicht nennenswert zusammendrückbaren Kunststoff oder Metall bestehen kann. Für die Montage von Schaltvorrichtungen kann ein Satz von Distanzringen mit unterschiedlichen Dicken bereitgestellt werden, wobei die Distanzring-Dicken zum Beispiel eine Zehntelmillimeter- Staffelung haben können. Durch Auswählen eines Distanzrings geeigneter Dicke können dann allfällige, durch Fabrikationsungenauigkeiten bedingte Abweichungen der Dicke des plattenartigen Teils 511 und der axialen Abmessung des Halses 523a von den vorgesehenen Sollwerten kompensiert werden, so dass die Vorderseite der Betätigungswand 523e trotz Fabrikationsungenauigkeiten möglichst genau bündig mit der Vorderseite 511c des plattenartigen Teils gemacht werden kann.

In der Figur 11 ist eine Einrichtung 601 mit einem Träger 603 ersichtlich. Dieser besitzt einen plattenartigen Teil 611 mit mindestens einem durchgehenden Loch 611a, das durch eine Bohrung mit einer glatten, zylindrischen Begrenzungsfläche gebildet ist. Auf der Vorderseite 611c des plattenartigen Teils ist eine "Design"-Deck-Folie 613 aufgeklebt, deren Vorderseite wiederum die Vorderseite 605 des Trägers 603 bildet. Eine Schaltvorrichtung 621 besitzt ein Gehäuse 623 mit einem Hals 623a. Dessen Mantel besitzt eine zylindrische, glatte Aussenfläche und ist durch eine in übertriebener Dicke gezeichnete Schicht Klebstoff 629 im Loch 611a festgeklebt, wobei der Klebstoff 629 auch noch als Dichtungsmittel dient und die Verbindung des Halses 623 mit dem plattenartigen Teil 611 abdichtet. Der Klebstoff 629 ist vorzugsweise derart beschaffen, dass die Kleb-Verbindung durch Erwärmen des Klebstoffs auf eine oberhalb der normalen Zimmertemperatur liegende, mindestens 50° C und beispielsweise mindestens oder ungefähr 60° C sowie beispielsweise bis 80° C betragende Temperatur wieder gelöst werden kann. Ein solcher Klebstoff ist zum Beispiel unter der Bezeichnung "Loctite 222" im Handel erhältlich. Zwischen der Rückseite 607 des Träger 603 und der Schulter 623f des Gehäuses ist ein Distanzring 639 angeordnet. Die Folie 613 ist bei ihrem sich nicht vor einer Betätigungswand 623e befindenden Bereich auf ihrer Vorderseite durch eine Vielzahl kleiner, buckelförmiger Erhöhungen 613a aufgerauht, während vor der bzw. jeder sich vor einer Betätigungswand 623e befindende, ein Betätigungs- und/oder Tast-Feld 615 definie rende Abschnitt der Folie ein glatte Vorderseite hat, wodurch das Feld 615 für eine Person mittels des Tastsinns erspürbar und von dem das Feld umgebenden Bereich der Folien-Vorderseite unterscheidbar wird.

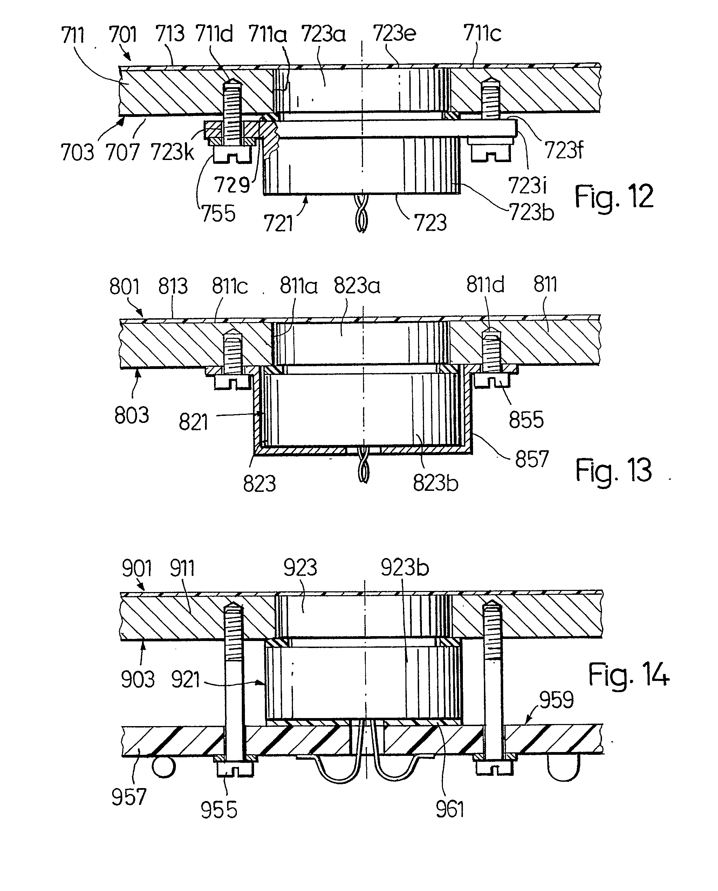

Bei der in der Figur 12 dargestellten Einrichtung 701 hat der Träger 703 einen plattenartigen Teil 711, ein durchgehendes, durch eine Bohrung gebildetes Loch 711a und mindestens zwei um dieses herum verteilte, von der Rückseite 707 des Trägers her in den plattenartigen Teil gebohrte, und mit Innengewinden versehene Löcher 711d. Auf die Vorderseite 611c des plattenartigen Teils 611 ist wiederum eine "Design"-Deck-Folie 613 aufgeklebt. Eine Schaltvorrichtung 721 besitzt ein Gehäuse 723 mit einem zylindrischen Hals 723a, der satt oder mit kleinem, radialem Spiel im Loch 711 steckt, und einen Kopf 723b. Die über einen Dichtungs- und/oder Distanzring 729 an der Rückseite 707 des Trägers anliegende Schulter 723f ist durch einen radial nach aussen ragenden Bund 723i gebildet, der den Löchern 711d zugeordnete, durchgehende Löcher 723k besitzt. Das Gehäuse 723 ist mit die Löcher 723k durchdringenden und in die Löcher 711d eingeschraubten Schrauben 755 derart lösbar am plattenartigen Teil 711 befestigt, dass die Vorderseite der Betätigungswand 723 bündig mit der Vorderseite 711c des plattenartigen Teils 711 ist.

Der Träger 803 der in der Figur 13 gezeichneten Einrichtung 801 besitzt einen plattenartigen Teil 811 mit einer auf dessen Vorderseite 811c aufgeklebten "Design"-Deck-Folie 813. Der plattenartige Teil 811 ist mit den Löchern 711a, 711d entsprechenden Löchern 811a, 811d versehen. Eine Schaltvorrichtung 821 weist ein Gehäuse 823 auf, das einen im Loch 811a sitzenden, zylindrischen Hals 823a sowie einen Kopf 823b besitzt. Am dem Hals abgewandten Ende des Kopfs 823b greift ein bügelförmiger Halter 857 an, der mit den Schrauben 755 entsprechenden Schrauben 855 am plattenförmigen Teil 811 festgeschraubt ist und die Schaltvorrichtung lösbar am plattenförmigen Teil 811 befestigt.

Die in der Figur 14 gezeichnete Einrichtung 901 weist einen Träger 903 mit einem plattenförmigen Teil 911 sowie mindestens eine Schaltvorrichtung 921 auf, die analog wie die entsprechenden Teile der Einrichtung 801 ausgebildet sind. Die Schaltvorrichtung 921 ist mit Schrauben 955 und einem Halter 957 lösbar am plattenartigen Teil 911 befestigt. Während der in der Figur 13 ersichtliche Halter 857 ausschliesslich zur Befestigung einer Schaltvorrichtung dient, hat der in der Figur 14 ersichtliche Halter 957 noch eine andere Funktion. Der Halter 957 ist nämlich durch die Platte einer gedruckten Schaltung 959 gebildet und greift beispielsweise über eine elektrisch isolierende Zwischenlage 961 am Kopf 923b des Gehäuses 923 der Schaltvorrichtung und eventuell zusätzlich noch an mindestens einer anderen Schaltvorrichtung an.

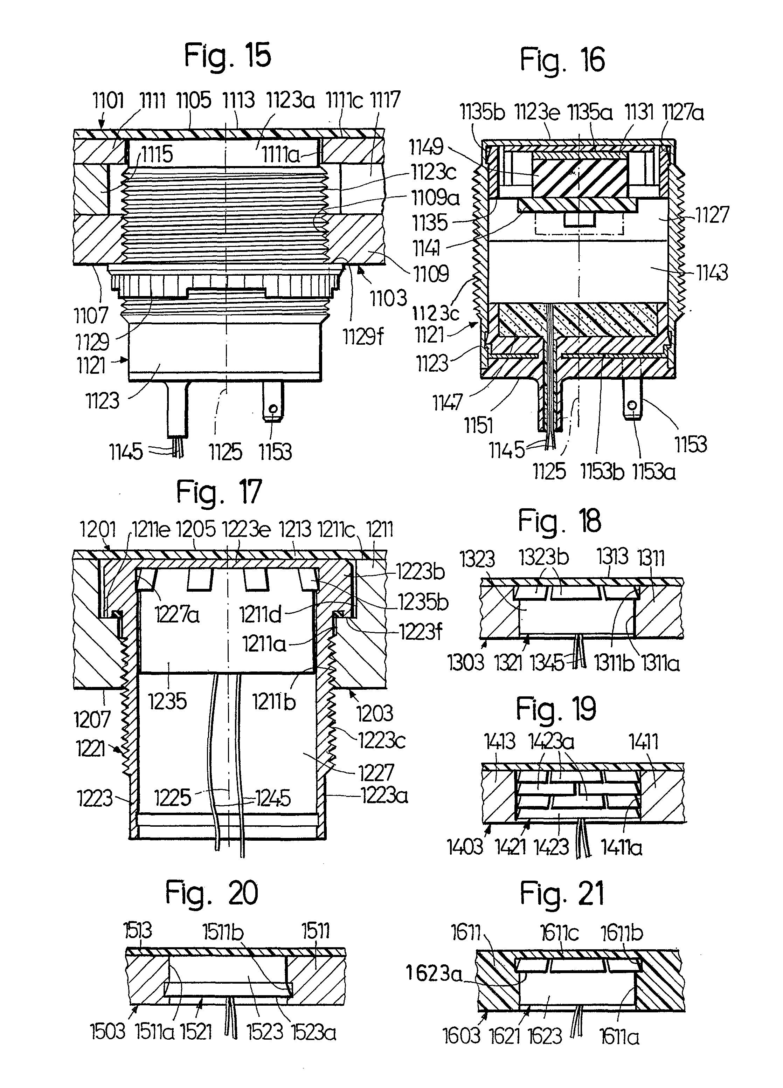

Die in der Figur 15 ersichtliche, elektrische Steuer-und/oder Schalt-Einrichtung 1101 weist einen im allgemeinen ebenen, plattenförmigen Träger 1103 mit einer Vorderseite 1105 sowie einer Rückseite 1107 auf. Der Träger 1103 besitzt einen die Rückseite 1107 bildenden, hinteren, plattenartigen Teil 1109, einen vorderen, dünneren, plattenartigen Teil 1111 und eine auf dessen Vorderseite 1111c aufgeklebte, die Träger-Vorderseite 1105 bildende "Design"-Deck-Folie 1113. Die beiden je aus einer ebenen, zum Beispiel metallischen Platte oder Tafel bestehenden, plattenartigen Teile 1109, 1111 sind durch einen Zwischenraum getrennt und durch in diesem angeordnete Distanz- und/oder Verbindungselemente 1115 miteinander verbunden. Im besagten Zwischenraum sind ferner elektronische Schaltungsmittel 1117 und möglicherweise noch andere Vorrichtungen vorhanden, die eventuell auch noch als Distanz- und Verbindungsmittel dienen können. Der Träger 1103 ist für die bzw. jede an ihm befestigte, elektrische Schaltvorrichtung 1121 mit einem Loch versehen, das durch zwei durchgehende Löcher 1109a, 1111a gebildet ist, die hintereinander in den plattenartigen Teilen 1109 bzw. 1111 angeordnet sind. Das Loch 1109a ist kreisförmig und mit einem Innengewinde versehen. Das Loch 1111a ist ebenfalls kreisförmig, hat aber einen etwas kleineren Durchmesser als das Loch 1109a und kein Gewinde. Die separat in der Figur 16 gezeichnete, elektrische Schaltvorrichtung 1121 weist ein metallisches Gehäuse 1123 mit einer Achse 1125 auf, die selbstverständlich mit der Achse der beiden Löcher 1109a, 1111a zusammenfällt. Das Gehäuse 1123 hat an seinem vorderen Ende einen Endabschnitt 1123a, dessen Stirnseite die Betätigungswand 1123e bildet und dessen zylindrischer Mantel mit höchstens kleinem Spiel in das Loch 1111a hineinpasst. An den Endabschnitt 1123a schliesst ein einen etwas grösseren Aussendurchmesser aufweisender Gehäuseabschnitt mit einem Aussengewinde 1123c an, der in das Innengewinde des Lochs 1109a eingeschraubt ist. Eine auf das Aussenfewinde 1123c aufgeschraubte Mutter 1129 hat eine an der Rückseite des plattenartigen Teils 1109 und damit an der Rückseite 1107 des ganzen Trägers 1103 anliegende Auflagefläche 1129f und sichert das Gehäuse 1123 in einer Stellung, in welcher die Vorderseite von dessen Betätigungswand 1123e bündig mit der Vorderseite 1111c des plattenartigen Teils 1111 ist.

Der im allgemeinen zylindrische Innenraum 1127 des Gehäuses 1123 besitzt an seinem vorderen Ende eine Rast-Erweiterung 1127a. Im Gehäuse 1123 ist ein einstückiger, aus elektrisch isolierendem Kunststoff bestehender Support 1135 eingesetzt. Dieser besitzt einen satt in das Gehäuse hineinpassenden Ring und einen durch vier Schenkel mit diesem verbundenen, dünnen, parallel zur Gehäuse-Achse 1125 leicht biegbaren Steg 1135a, der mit seiner einen, flachen Seite an der Innenfläche der Betätigungswand 1123e anliegt. Das beispielsweise die Form eines rechteckigen Plättchens aufweisende, piezoelektrische Element 1131 liegt an der der Betätigungswand 1123e abgewand ten Seite des Stegs 1135a an und ist mit diesen verklebt. Der Support 1135 weist ferner zwei vom Ring weg nach vorne ragende, etwas federnde Finger auf, die am vorderen Ende widerhakenförmig ausgebildet sind und die Rast-Erweiterung 1127a hintergreifende Rast-Vorsprünge 1135b haben. Der Support 1135 wird durch die von der Rast-Erweiterung 1127a und den mit den Rast-Vorsprüngen 1127a versehenen Fingern gebildeten Rast-Mittel im Gehäuse festgehalten und ist beispielsweise noch zusätzlich mit diesem verklebt. Die elektronischen Schaltungsmittel der Schaltvorrichtung 1121 weisen eine erste Schaltstufe 1141 und eine zweite Schaltstufe 1143 auf. Die erste Schaltstufe 1141 besitzt ein zur Bildung einer gedruckten Schaltung dienendes, auf dem Ring des Supports 1135 aufliegendes und mit federnden Rast-Haken an diesem gehaltenes Plättchen. Die zweite, schematisch als Block angedeutete Schaltstufe 1143 ist auf der der Betätigungswand 1123e abgewandten Seite der ersten Schaltstufe im Gehäuse-Innenraum 1127 angeordnet. Zwischen dem piezoelektrischen Element 1131 und der ersten Schaltstufe 1141 ist ein Andrück- und/oder Leiter-Körper 1149 mit einer elektrisch isolierenden, gummielastischen Matrix und zwei in dieser eingebetten und/oder an dieser angeordneten, schichtförmigen, elektrisch leitenden Leiterbahnen gehalten. Die Matrix greift derart mit einer zur Betätigungswand hin gerichteten Druckkraft am piezoelektrischen Element an, dass die Leiterbahnen im Kontakt mit den Signalabehmern des piezoelektrischen Elements gelangen und diese elektrisch leitend mit der ersten Schaltstufe verbinden. Diese ist elektrisch leitend mit der zweiten Schaltstufe 1143 verbunden, die ihrerseits elektrisch mit zwei Anschlüssen 1145, etwa isolierten Drähten oder Litzen verbunden ist. Eine Zugentlastungsvorrichtung 1151 besitzt einen beim hinteren Ende des Gehäuses 1123 in dieses eingesetzten und durch Rast-Nasen verrasteten Abschluss- und Halteteil mit einem angeformten Stutzen, durch den hindurch die Anschlüsse aus dem Gehäuse herausgeführt sind. Ein elektrisch leitendes Gehäuse-Verbindungsorgan 1153 besitzt einen nach hinten von Gehäuse wegragenden Gehäuse-Anschluss 1153a und einen im Abschluss- und Halteteil der Zugentlastungsvorrichtung gehaltenen Verbindungssteg 1153b, der zusammen mit den Rast-Nasen der Vorrichtung 1151 mit dem Gehäuse verrastet ist und dieses elektrisch leitend mit dem Gehäuse-Anschluss 1153a verbindet. Der zwischen der zweiten Schaltstufe 1143 und dem hinteren Ende des Gehäuses 1123 vorhandene und nicht von der Zugentlastungsvorrichtung 1151 eingenommene Bereich des Gehäuse-Innenraums 1127 ist mit einer elektrisch isolierenden und den Gehäuse-Innenraum dicht abschliessenden Vergussmasse 1147 vergossen. Das erste Schaltstufe 1141 ist ausgebildet, um verhältnismässig kleine Spannungen und Ströme zu schalten, die beispielsweise bis 35 V bzw. 0,2 A betragen können. Die zweite Schaltstufe 1143 dient als Schalt-Verstärker und ermöglicht grössere, zum Beispiel bis 230 V und 3 A betragende Spannungen zu schalten. Die Aufteilung der elektronischen Schaltungsmittel in zwei separat in ein Gehäuse einbaubare, elektrisch hintereinander schaltbare Schaltstufen ermöglicht, abhängig von der gewünschten Schaltleistung entweder - wie in der Figur 16 gezeichnet - eine erste und zweite Schaltstufe oder aber nur die erste Schaltstufe in ein Gehäuse einzubauen. Im leteren Fall kann der in der Figur 16 von der zweiten Schaltstufe eingenommene Raum beispielsweise auch noch mit Vergussmasse ausgefüllt werden.

Die zum Teil in der Figur 17 gezeichnete, elektrische Steuer- und/oder Schalt-Einrichtung 1201 weist einen Träger 1203 auf, der mindestens in einem Bereich plattenförmig ist und eine ebene Vorderseite 1205 sowie eine Rückseite 1207 hat. Der Träger besitzt einen beispielsweise durch eine metallische Platte gebildeten, ebenen, plattenartigen Teil 1211. Dieser besitzt mindestens ein abgestuftes Loch 1211a und normalerweise mehrere solche. Das Loch 1211a hat einen mit einem Innengewinde 1211b versehenen Abschnitt und eine die Vorderseite 1211c des plattenartigen Teils 1211 mündende Erweiterung 1211d. Zwischen dem Innengewinde 1211b und der Erweiterung 1211d ist noch ein kurzer, gewindeloser Zwischenabschnitt vorhanden, dessen Durchmesser geringfügig grösser als derjenige des Innengewinde-Grundes aber kleiner als der Durchmesser der Erweiterung 1211d ist. Die letztere bildet an ihrem der Träger-Rückseite 1207 zugewandten Ende eine radiale Auflagefläche 1211e. Auf der Vorderseite 1211c des plattenartigen Teils 1211 ist eine das Loch 1211a und jedes allenfalls noch vorhandene, diesem entsprechende Loch abdeckende "Design"-Deck-Folie 1213 befestigt.

Eine im Loch 1211a befestigte elektrische Schaltvorrichtung 1221 besitzt ein beispielsweise metallisches, äussers Gehäuse 1223 mit einer einstückigen, am hinteren Ende offene Hülse, die einen Hals 1223a sowie einen Kopf 1223b bildet. Der Hals hat einen mit einem Aussengewinde 1223c versehenen Abschnitt und ist derart mit dem Innengewinde 1211b verschraubt, dass der Kopf mit einer Auflagefläche 1223f auf der Auflagefläche 1211e des Lochs 1211a aufliegt. Der Kopf ist beim inneren Ende der Auflagefläche 1223f noch mit einer Ringnut versehen, in die ein das Gehäuse 1223 gegen den plattenartigen Teil abdichtender Dichtungsring eingesetzt ist. Das Gehäuse 1223 ist an seinem vorderen Ende durch eine Betätigungswand 1223e abgeschlossen, deren vordere, äussere Begrenzungsfläche möglichst genau bündig mit der Vorderseite 1211c des plattenartigen Teils 1211 ist. Das Gehäuse 1223 ist mindestens im allgemeinen rotationssymmetrisch zu seiner Achse 1225 und hat einen im allgemeinen zylindrischen Innenraum 1227, der an seinem an die Betätigungswand angrenzenden Ende mit einer ringförmigen Rast-Erweiterung 1227a versehen ist. Im vorderen Bereich des Innenraums 1227 ist ein inneres Gehäuse 1235 eingesetzt, dessen Mantel an seinen vorderen Enden mit über seinen Umfang verteilten, ein wenig federnden Rast-Vorsprüngen 1235b versehen ist, die in die Rast-Erweiterung 1227a eingreifen und mit dieser zusammen Rast-Mittel bilden. Das innere Gehäuse 1235 ist durch diese Rast-Mittel mit dem äusseren Gehäuse 1223 verbunden, jedoch beispielsweise noch zusätzlich mit diesem verklebt. Das innere Gehäuse ist an seinem vorde ren Ende durch eine in axialer Richtung biegbare Betätigungswand begrenzt. Ein plättchenförmiges, piezoelektrisches Element ist beispielsweise ähnlich wie das piezoelektrische Element 31 an der Betätigungswand 23e oder ähnlich wie das piezoelektrische Element 1131 am Steg 1135a des Supports 1135 angeordnet und gehalten. Das innere Gehäuse enthält ferner mit dem piezoelektrischen Element verbundene, elektronische Schaltungsmittel, die ihrerseits mit aus dem inneren Gehäuse 1223 herausgeführten Anschlüssen 1245 verbunden sind. Das innere Gehäuse 1235 kann ähnlich wie die früher beschriebenen Gehäuse aus einer einstückigen, am hinteren Ende wandlosen Hülse gebildet und am hinteren Ende durch eine Zugentlastungsvorrichtung sowie eine Vergussmasse abgeschlossen sein. Der sich hinter dem inneren Gehäuse befindende Bereich des Innenraums 1227 des äusseren Gehäuses 1223 ist in der Figur 17 als leerer Hohlraum gezeichnet, könnte jedoch noch durch ein Abschlusselement und/oder eine Vergussmasse abgeschlossen sein. Ferner könnte man in den freien Bereich des Gehäuse-Innenraums 1227 noch zusätzliche, funktionsmässig der zweiten Schaltstufe 1143 entsprechende Schaltungsmittel und eine Zugentlastungsvorrichtung einsetzen.

Während alle vorher anhand der Zeichnung beschriebenen Schaltvorrichtungen vom an die Rückseite des Trägers an diesen angrenzenden Raum her in das zugeordnete Loch des Trägers einsetzbar sind, wird die Schaltvorrichtung 1221 bei der Montage von der Vorderseite des plattenartigen Teils 1211 her in diesen eingesetzt, und zwar selbstverständlich vor dem Anbringen der "Design"-Deck-Folie 1213. Falls die Schaltvorrichtung 1221 der Einrichtung 1201 nachträglich - d.h. nach der Fertigstellung der letzteren - ausgewechselt werden soll, kann die Folie 1213 vorher entfernt und nachher wieder angebracht oder nötigenfalls durch eine neue Folie ersetzt werden.

Der zum Teil in der Figur 18 ersichtliche Träger 1301 weist einen plattenartigen Teil 1311 mit mindestens einem durchgehen den Loch 1311a auf. Dieses besteht aus einer zylindrischen Bohrung und einer beim vorderen Ende angeordneten Rast-Erweiterung 1311b. Die Vorderseite des plattenartigen Teils ist mit einer das Loch 1211a abdeckenden "Design"-Deck-Folie 1313 versehen. Eine elektrische Schaltvorrichtung 1321 besitzt ein Gehäuse 1323, dessen Mantel beim vordern Ende mit etwas federnden, in die Rast-Erweiterung 1311b eingreifenden, wderhakenförmigen Rast-Vorsprüngen 1323b versehen ist. Diese bilden Schultern und liegen auf der von der Rast- Erweiterung 1311b gebildeten, radialen Fläche des Gehäuses auf. Das Gehäuse 1323 wird durch die von der Rast-Erweiterung und den Rast-Vorsprüngen gebildeten Rast-Mittel sowie die Folie 1313 im plattenartigen Teil 1311 gehalten und ist vorzugsweise zusätzlich mit diesem verklebt. Das Gehäuse enthält wiederum ein piezoelektrisches Element und elektronische Schaltungsmittel, die mit Anschlüssen 1345 verbunden sind.

Der in der Figur 19 gezeichnete Träger 1403 weist einen plattenartigen Teil 1411 mit einem durchgehenden, zylindrischen Loch 1411a und eine "Design"-Deck-Folie 1413 auf. Die im Loch 1411a eingesetzte, elektrische Schaltvorrichtung 1421 besitzt ein Gehäuse 1423, dessen Mantel mit über seinen Umfang verteilten und in axialer Richtung gegeneinander versetzten, sägezahnförmig profilierten, vorzugsweise etwas federnden Klemm-Vorsprüngen 1423a versehen ist. Das Gehäuse 1423 ist in das Loch 1411a eingepresst, durch die Klemm-Vorsprünge 1423a im plattenförmigen Teil 1411 gehalten und zusätzlich mit diesem verklebt.

Der Träger 1503 gemäss der Figur 20 besitzt einen plattenartigen Teil 1511 mit mindestens einem durchgehenden Loch 1511a, das durch eine Bohrung mit einer ringförmigen Rast-Nut 1511b gebildet ist. Auf der Vorderseite des Trägers ist eine das Loch abdeckende "Design"-Deck-Folie 1513 festgeklebt. Die im Loch befestigte Schaltvorrichtung 1521 besitzt ein Gehäuse 1523 mit einem ringförmigen, ein wenig federnden Rast- Vorsprung 1523a, der in die Rast-Nut 1511b eingreift und das Gehäuse dadurch mit dem Träger 1503 verbindet, wobei das Gehäuse vorzugsweise auch noch mit dem plattenartigen Teil 1511 verklebt ist.

Der in der Figur 21 ersichtliche Träger 1603 weist einen einstückigen, plattenartigen Teil 1611 mit mindestens einem Loch 1611a, nämlich einem in die Rückseite des plattenartigen Teils mündenden Sackloch auf. Dieses besteht zur Hauptsache aus einer zylindrischen Bohrung, die am inneren Ende mit einer Rast- Erweiterung 1611b versehen ist. Auf der Vorderseite des plattenartigen Teils 1611 ist das Loch 1611a durch einen folienartigen, in der Richtung der Achse des Lochs biegbaren Abschnitt 1611c des Teils 1611 abgeschlossen, der mit dem das Loch umschliessenden Bereich des plattenartigen Teils 1611 zusammenhängt. Eine elektrische Schaltvorrichtung 1621 hat ein Gehäuse 1623 mit über seinen Umfang verteilten, federnden, in die Rast-Erweiterung 1611b eingreifenden Rast-Vorsprüngen 1623a. Das Gehäuse ist durch die von der Rast-Erweiterung und den Rast-Vorsprüngen gebildeten Rast-Mittel mit dem plattenartigen Teil 1611 verbunden und zusätzlich mit diesem verklebt. Der bzw. jeder folienartige Abschnitt 1611c des plattenartigen Teils 1611 kann mit einer zur Bezeichnung eines Tast-Feldes dienenden Markierung versehen sein. Es kann jedoch statt dessen noch eine "Design"- Deck-Folie auf die Vorderseite des plattenartigen Teils aufgeklebt werden.

Der die Gehäuse 1323, 1423, 1523, 1623 allenfalls noch mit dem betreffenden, plattenartigen Teil verklebende Klebstoff kann beispielsweise gleich wie der Klebstoff 629 durch Erwärmen lösbar sein. Falls eine der Schaltvorrichtungen 1321, 1421, 1521, 1621 nachträglich ersetzt werden soll, kann man sie - nötigenfalls unter Zerstörung ihres beispielsweise aus Kunststoff bestehenden Gehäuses - auf der Rückseite des betreffenden Trägers herausnehmen. Bei den Trägern 1303, 1403, 1503 kann man statt dessen zuerst die "Design-Deck-Folie entfernen oder mit einem Loch versehen und danach die zu ersetzende Schaltvorrichtung auf der Vorderseite des betreffenden, plattenartigen Teils herausnehmen.

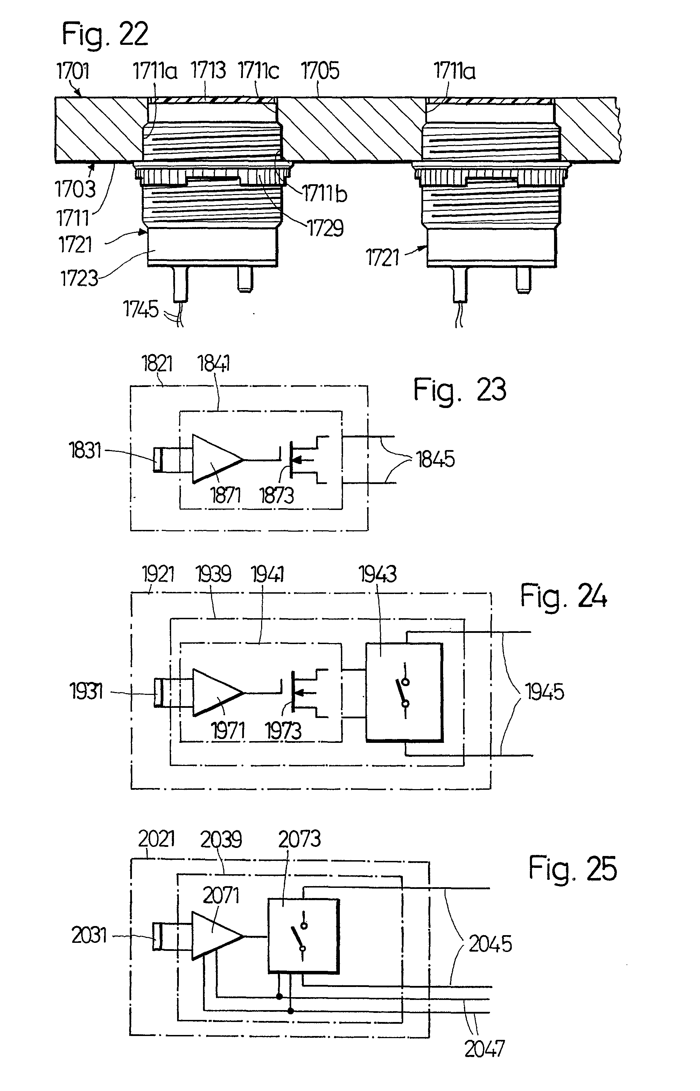

Die in der Figur 22 dargestellte Steuer- und/oder Schalt-Einrichtung 1701 weist einen Träger 1703 mit einem plattenartigen Teil 1711 auf, der mit durchgehenden Löchern 1711a versehen ist. Jedes Loch 1711a hat einen mit einem Innengewinde 1711b versehenen Abschnitt und einen in die Vorderseite des plattenartigen Teils 1711 mündenden, engeren, gewindelosen Abschnitt 1711c. Die zur Einrichtung 1701 gehörenden, elektrischen Schaltvorrichtungen 1721 haben je ein Gehäuse 1723, das gleich oder ähnlich wie dasjenige der Schaltvorrichtung 1121 ausgebildet, in das Innengewinde 1711b eingeschraubt und mit einer Mutter 1729 gesichert ist.

Jede Schaltvorrichtung 1721 kann im Inneren ihres Gehäuses 1723 gleiche oder ähnliche Teile wie die Schaltvorrichtung 1121 enthalten und besitzt aus dem Gehäuse 1723 herausgeführte Anschlüsse 1745. Die Einrichtung 1701 unterscheidet sich jedoch von der Einrichtung 1101 insbesondere dadurch, dass anstelle einer auf der Vorderseite des plattenartigen Teils angebrachten "Design"-Deck-Folie auf der Vorderseite der Betätigungswand jedes Gehäuses 1723 eine einzelne, eine Markierung tragende "Design"-Deck-Folie 1713 aufgeklebt ist. Diese ist gleich wie der Lochabschnitt 1711c kreisförmig und hat einen nur geringfügig kleineren Durchmesser als dieser, so dass zwischen dem Folienrand und der Innenfläche des Lochabschnitts höchstens ein im Vergleich zu dessen Durchmesser kleiner Spalt freibleibt. Ferner ist die Einschraubtiefe jedes Gehäuses 1723 derart festgelegt, dass die Vorderseite der auf das betreffende Gehäuse aufgeklebten Folie 1713 mindestens ungefähr bündig mit der bei diesem Träger 1703 dessen Vorderseite 1705 bildenden Vorderseite des plattenartigen Teils 1711 ist.

Es sei noch darauf hingewiesen, dass die Schaltvorrichtungen aller beschriebenen Ausführungsbeispiele am zugeordneten Träger mit Befestigungsmitteln befestigt sind die sich vollständig hinter der von der Vorderseite des formfesten, plattenartigen Teils aufgespannten Ebene und damit auch vollständig hinter der Vorderseite des betreffenden Trägers befinden.

Die Figur 23 zeigt ein mögliches Blockschema einer durch einen strichpunktierten Block angedeuteten und hier mit 1821 bezeichneten, elektrischen Schaltvorrichtung. Beim in der Figur 23 dargestellten Blockschema könnte es sich jedoch beispielsweise um dasjenige der Schaltvorrichtung 21 oder von verschiedenen anderen der vorgängig beschriebenen Schaltvorrichtungen handeln. Das in der Figur 23 mit 1831 bezeichnete, piezoelektrische Element ist mit im Gehäuse der Schaltvorrichtung angeordneten, elektronischen Schaltungsmitteln 1841 verbunden. Diese weisen eine Signalaufbereitungs- und/oder Steuerschaltung 1871 mit einem Verstärker auf, der zur Verstärkung und/oder Formung der vom piezoelektrischen Element 1831 gelieferten Signale und/oder zur Impedanzanpassung ausgebildet ist. Der Ausgang der Signalaufbereitungs- und/oder Steuerschaltung 1871 ist mit einem elektrisch steuerbaren, durch einen Schalt-Feldeffekt-Transistor gebildeten Schaltorgan 1873 verbunden, das mit zwei aus dem Gehäuse herausgeführten Anschlüssen 1845 verbunden ist. Die Schaltungsmittel 1841 sind also rein elektronisch und weisen keine mechanisch schaltbaren Kontakte auf. Die Schaltungsmittel 1841 sind ferner derart ausgebildet, dass zu ihrem Betrieb ausser der an die beiden schaltbaren Anschlüsse 1845 angelegten, zu schaltenden, elektrischen Spannung keine andere, elektrische Hilfs- und/oder Betriebsspannung erforderlich ist. Dementsprechend sind abgesehen vom allenfalls noch zum Verbinden des Gehäuses mit einem Massen- oder Erdungsanschluss der Einrichtung vorhandenen Gehäuse-Anschluss keine anderen Anschlüsse notwendig. Die Schaltungsmittel können zudem beispielsweise derart ausgebildet sein, dass ein und dieselbe Schaltvorrichtung wahlweise mit Wechsel- oder Gleichspannungen betrieben werden kann, deren Nennwerte in einem gewissen, vorgegebenen, sich zum Beispiel von ungefähr 1,5 bis 35 V erstreckenden Bereich liegen. Der maximal zulässige, schaltbare Strom kann beispielsweise bis 0,3 A betragen. Die Schaltungsmittel und ihr Schaltorgan können jedoch auch ausgebildet sein, um beispielsweise im Bereich von 60 bis 230 V liegende Spannungen und bis 3 A betragende Ströme zu schalten. Wenn mit einem Finger über die Betätigungswand eine Druckkraft auf das piezoelektrische Element 1831 ausgeübt wird, führt dieses den als elektrisches Schaltorgan dienenden Schaltungsmitteln 1841 ein elektrisches Signal zu. Die Schaltungsmittel können derart ausgebildet sein, dass der Feldeffekt-Transistor beim Eintreffen eines solchen Signals seinen Schaltzustand vorübergehend ändert und vorübergehend eine elektrisch leitende Verbindung zwischen den beiden Anschlüssen 1845 erstellt oder unterbricht. Eine mit den Schaltungsmitteln 1841 ausgerüstete Schaltvorrichtung kann also die Funktion eines Tast-Schalters oder, kürzer gesagt, Tasters ausüben, wobei die Dauer der beim Betätigen der Schaltvorrichtung abgegebenen Impulse abhängig von der Dauer des von einer Bedienungsperson mit einem Finger auf die Betätigungswand ausgeübten Druckes etwas variieren kann. Die Schaltungsmittel 1841 können jedoch auch ausgebildet sein, um die Funktion eines Rast- bzw. EIN/AUS-Schalters oder abhängig von der Dauer und/oder Stärke der auf die Schaltvorrichtung ausgeübten Druckkraft wahlweise die Funktion eines Tast- oder eines Rast-Schalters auszuüben.

Die Figur 24 zeigt ein Blockschema einer mit 1921 bezeichneten, elektrischen Schaltvorrichtung, bei der es sich zum Beispiel um die Schaltvorrichtung 1121 oder um eine andere Schaltvorrichtung handeln könnte, für die vorher anhand der Zeichnung der mechanische Aufbau und/oder die Befestigung an einem Träger beschrieben wurde. Die Schaltvorrichtung 1921 weist ein piezoelektrisches Element 1931 und elektronische Schaltungsmittel 1939 mit einer ersten Schaltstufe 1941 und einer zweiten Schaltstufe 1943 auf. Die erste Schaltstufe 1941 kann gleiche oder ähnliche Komponenten aufweisen wie die elektronischen Schaltungsmittel 1841, wobei das zur ersten Schaltstufe gehörende, erste Schaltorgan zum Beispiel das Schalten von Spannungen mit bis zu 35 V betragenden Werten ermöglicht. Der Ausgang de ersten Schaltstufe 1941 ist mit einem Steuer-Eingang der zweiten Schaltstufe 1943 verbunden, die auch noch mit den aus dem Gehäuse der Schaltvorrichtung 1921 herausgeführten Anschlüssen 1945 verbunden ist. Die zweite Schaltstufe kann beispielsweise ausgebildet sein, um Gleich- oder Wechselspannungen mit Werten von ungefähr 60 V bis ungefähr 230 V und Ströme mit Werten bis 3 A zu schalten. Die zweite Schaltstufe 1943 kann wie die erste Schaltstufe aus rein elektronischen Komponenten aufgebaut sein und als Schaltorgan beispielsweise mindestens einen Schalt-Feldeffekt-Transistor und/oder mindestens eine andere, schaltbare, elektronische Komponente aufweisen. Es wäre jedoch auch möglich, die zweite Schaltstufe mit einem Relais auszurüsten.

Die Figur 25 zeigt noch ein anderes, mögliches Blockschema der im Gehäuse einer hier mit 2021 bezeichneten Schaltvorrichtung untergebrachten Komponenten. Bei dieser Variante ist ein piezoelektrisches Element 2031 mit elektronischen Schaltungsmitteln 2039 verbunden. Die elektronischen Schaltungsmittel 2039 weisen eine Signalaufbereitungs- und/oder Steuerschaltung 2071 und ein elektrisch steuerbares Schaltorgan 2073 auf. Das letzere kann - abhängig von der gewünschten Schaltleistung sowie Schaltfunktion - mindestens einen Feldeffekt-Transistor und/oder eventuell ein Relais aufweisen. Die Signalaufbereitungs- und/oder Steuerschaltung 2071 kann analog wie die Schaltung 1871 einen Verstärker und - abhängig von der vorgesehenen Funktion der Schaltvorrichtung - eventuell noch Logikschaltkomponenten, etwa mindestens eine Tor- und/oder Kippschaltung aufweisen. Die Schaltvorrichtung 2021 weist zwei mit dem Schaltorgan verbundene und aus ihrem Gehäuse herausgeführte, durch das Schaltorgan 2073 schaltbare, d.h. elektrisch leitend verbind- oder trennbare Anschlüsse 2045 und noch zwei Anschlüsse 2047 auf, mit der Aufbereitungs- und/oder Steuer schaltung 2071 sowie möglicherweise auch mit dem Schaltorgan 2073 verbundene sowie aus dem Gehäuse herausgeführt sind und zum Zuführen einer beispielsweise 5 V betragenden Hilfs-und/oder Betriebsspannung dienen. Die letztere ermöglicht, die Schalteigenschaften der Schaltvorrichtung in mancher Weise zu variieren und/oder zu verbessern.

Die Einrichtungen und ihre Schaltvorrichtungen können noch auf andere Arten geändert werden. Zum Beispiel könnten die Gehäuse 23, 423, 523, 623, 723, 823, 923, 1123, 1223 statt aus einem metallischen Material aus Kunststoff hergestellt werden, der eventuell mit Fasern verstärkt sein kann.

Eine Schaltvorrichtung kann ferner noch in anderer Weise lösbar an einem plattenartigen Teil eines Trägers befestigt werden. Beispielsweise könnten die Schrauben 755, 855, 955 durch Gewindebolzen und Muttern ersetzt werden. Des weiteren könnten der Träger und das Gehäuse einer Schaltvorrichtung mit zusammen einen Bajonettenverschluss bildenden Befestigungsmitteln versehen werden.

Wie es aus der Beschreibung der Schaltvorrichtung 1121 hervorgeht, ist deren piezoelektrisches Element 1131 am Steg 1135a eines Supports 1135 festgeklebt und wird ferner durch den Andrück- und/oder Leiter-Körper 1149 federnd gegen den Steg des Supports gedrückt, der dadurch seinerseits gegen die Betätigungswand des Gehäuses gedrückt wird. Man könnte selbstverständlich auch bei allen anderen Schaltvorrichtungen einen Andrück- und/oder Leiter-Körper vorsehen, der das piezoelektrische Element federnd in Richtung zur Betätigungswand hin drückt. Eventuell könnte man dann darauf verzichten, das piezoelektrische Element unmittelbar oder mittelbar an der Betätigungswand oder an einem an einer solchen anliegenden Abschnitt eines Supports oder eines als Support dienenden, inneren Gehäuses anzukleben und das piezoelektrische Element lediglich durch die vom Andrück- und/oder Leiter-Körper erzeugte Druck kraft zum unmittelbaren oder mittelbaren Anliegen an einer Betätigungswand bringen.

Ferner kann man noch eine die Betätigungswand umschliessende Leuchtvorrichtung vorsehen. Wenn zum Beispiel eine in der Art der Schaltvorrichtung 21 ausgebildete Schaltvorrichtung noch mit einer Leuchtvorrichtung versehen werden soll, kann diese etwa einen mindestens zum Teil aus lichtdurchlässigem Kunststoff bestehenden Ring aufweisen, der innen ein auf das Aussengewinde 23c des Halses 23a aufgeschraubtes Innengewinde und aussen ein Aussengewinde besitzt, das in ein Gewindeloch des plattenartigen Teil des Trägers eingeschraubt ist. Dieser einen weiteren Teil des Gehäuses der Schaltvorrichtung bildende Ring kann dann innen über einen dem Ring 29 entsprechenden Dichtungsring an der Schulter 23f anliegen und aussen seinerseits eine Schulter bilden, mit der er über einen Dichtungs- und/oder Distanzring an der Rückseite des plattenartigen Teils des Trägers anliegt. Eine auf der Rückseite des mindestens teilweise lichtdurchlässigen Ringes vorhandene Nut kann mindestens eine Lichtquelle und nämlich beispielsweise eine Anzahl über den Ringumfang verteilter Leuchtdioden oder Lämpchen enthalten und beispielsweise mit einer Vergussmasse vergossen sein. Schaltvorrichtungen mit einer derartigen Leuchtvorrichtung können beispielsweise für Türöffner von Bahn- und Tramwagen, für Aufzüge oder für andere Zwecke verwendet werden, bei denen eine Beleuchtung der Schaltvorrichtung erforderlich ist.

Ferner könnte man die in den Gehäusen der verschiedenen Schaltvorrichtungen untergebrachten, elektronischen Schaltungsmittel mit einem manuell verstellbaren Stellorgan ausrüsten, das ermöglicht die Zeitdauer der beim manuellen Betätigen einer Schaltvorrichtung stattfindenden Schaltzustads-Änderungen, d.h. zum Beispiel die Dauer der erzeugten, elektrischen Impulse, einzustellen. Das Stellorgan und die Schaltungsmittel könnten zudem derart ausgebildet sein, dass die Schaltzustands-Änderungen in der einen Endstellung des Stellorgans gewissermassen unendlich lang dauert, so dass die Schaltvorrichtung ihren Schaltzustand erst bei der nächsten manuellen Betätigung wieder ändert und die Schaltvorrichtung dann die Funktion eines Rast-Schalters ausübt. Ein derartiges Stellorgan würde also ermöglichen, ein- und dieselbe Schaltvorrichtung wahlweise als Tast-Schalter oder als Rast-Schalter zu verwenden. Das Stellorgan könnte beispielsweise eine drehbaren Schaft aufweisen, der beim der Betätigungswand abgewandten Ende des ein piezoelektrisches Element enthaltenden Gehäuses - also zum Beispiel beim in der Figur 3 dargestellten Gehäuse bei dessen unterem Ende - ungefähr bündig mit dem Ende des Gehäuses ist oder möglicherweise ein wenig aus diesem herausragt und eine Schlitz zum Angreifen mit einem Schraubenzieher oder dergleichen aufweist. Ferner könnte dann eine Skala vorgesehen werden, die das mit dem Schlitz versehene Schaftende des Stellorgans umschiesst und einige Markierungen aufweist.

Im übrigen können Merkmale von vorgängig beschriebenen Ausführungsbeispielen der erfindungsgemässen Einrichtung selbstverständlich auf verschiedene Arten miteinander kombiniert werden.

## Patentansprüche

1. Einrichtung mit einem Träger (3, 103, 203, 303, 403, 503, 603, 703, 803, 903, 1103, 1203, 1303, 1603) und mindestens einer von diesem gehaltenen, ein piezoelektrisches Element (31, 1131, 1831, 1931, 2031) aufweisenden, elektrischen Schaltvorrichtung (21, 121, 221, 421, 521, 621, 721, 821, 921, 1121, 1221, 1321, 1421, 1521, 1621, 1721, 1821, 1921, 2021), wobei ein die Schaltvorrichtung (21, 121, 221, 421, 521, 621, 721, 821, 921, 1121, 1221, 1321, 1421, 1521, 1621, 1721, 1821, 1921, 2021) umgebender Bereich der Vorderseite (5, 105, 205, 305, 405, 505, 1105, 1205, 1605) des Trägers (3, 103, 203, 303, 403, 503, 603, 703, 803, 903, 1103, 1203, 1303, 1603) eine Ebene aufspannt und das piezoelektrische Element (31, 1031, 1131, 1831, 1931, 2031) derart hinter dieser angeordnet ist, dass es beim Einwirken einer Druckkraft von der an die Träger-Vorderseite (5, 105, 205, 305, 405, 505, 1105, 1205, 1605) angrenzenden Umgebung her ein elektrisches Signal erzeugen kann, dadurch gekennzeichnet, dass das bzw. jedes piezoelektrische Element (31, 1031, 1131, 1831, 1931, 2031) in einem Gehäuse (23, 123, 223, 423, 525, 623, 723, 823, 923, 1123, 1223, 1235, 1323, 1423, 1523, 1623, 1723) angeordnet ist, das sich mindestens teilweise in einem Loch (11a, 111a, 211a, 411a, 511a, 611a, 711a, 811a, 1109a, 1111a, 1211a, 1311a, 1411a, 1511a, 1611a) des Trägers (3, 103, 203, 303, 403, 503, 603, 703, 803, 903, 1103, 1203, 1303, 1603) befindet und eine zur Beaufschlagung durch die Druckkraft vorgesehene Betätigungswand (23e, 423e, 523e, 623e, 723e, 1123e, 1223e) aufweist.

2. Einrichtung nach Anspruch 1, dadurch gekennzeichnet, dass die entlang dem Loch-Umfang verlaufende Begrenzung des Lochs (11a, 111a, 211a, 411a, 511a, 611a, 711a, 811a, 1109a, 1111a, 1211a, 1311a, 1411a, 1511a, 1611a) des Trägers (3, 103, 203, 303, 403, 503, 603, 703, 803, 903, 1103, 1203, 1303, 1603) mindestens teilweise durch mindestens einen plattenartigen Teil (11, 111, 211, 411, 511, 611, 711, 811, 911, 1109, 1111, 1211, 1311, 1411, 1511, 1611, 1711) des Trägers (3, 103, 203, 303, 403, 503, 603, 703, 803, 903, 1103, 1203, 1303, 1603) gebildet ist und dass das Loch (11a, 111a, 211a, 411a, 511a, 611a, 711a, 811a, 1109a, 1111a, 1211a, 1311a, 1411a, 1511a, 1611a) auf der Rückseite des plattenartigen Teils (11, 111, 211, 411, 511, 611, 711, 811, 911, 1109, 1111, 1211, 1311, 1411, 1511, 1611, 1711) offen ist.

3. Einrichtung nach Anspruch 1 oder 2, dadurch gekennzeichnet, dass das bzw. jedes Gehäuse (23, 123, 223, 423, 525, 623, 723, 823, 923, 1123, 1323, 1423, 1523, 1623, 1723) derart am Träger (3, 103, 203, 303, 403, 503, 603, 703, 803, 903, 1103, 1303, 1603) befestigt ist, dass es ohne Beschädigung von diesem und beispielsweise auch ohne Beschädigung von ihm selbst aus dem Loch (11a, 111a, 211a, 411a, 511a, 611a, 711a, 811a, 1109a, 1111a, 1311a, 1411a, 1511a, 1611a) herausnehmbar ist.

4. Einrichtung nach einem der Ansprüche 1 bis 3, dadurch gekennzeichnet, dass das Gehäuse (23, 423, 523, 623, 723, 823, 923, 1223, 1323, 1523, 1623) oder eine auf dieses aufgeschraubte Mutter (1129, 1729) eine mit der Achse (25, 425, 525, 1125, 1225) des Gehäuses (23, 423, 523, 623, 723, 823, 923, 1123, 1223, 1323, 1523, 1623, 1723) einen - vorzugsweise rechten - Winkel bildende Auflagefläche (1129f) aufweist, die am Träger (3, 103, 203, 403, 503, 603, 703, 803, 903, 1103, 1203, 1303, 1503, 1603, 1703) angreift.

5. Einrichtung nach einem der Ansprüche 1 bis 4, dadurch gekennzeichnet, dass die Auflagefläche (1129f) an der Rückseite (7, 107, 207, 307, 407, 507, 1107) des Trägers (3, 103, 203, 303, 403, 503, 603, 703, 803, 903, 1103, 1603) anliegt.

6. Einrichtung nach einem der Ansprüche 1 bis 5, dadurch gekennzeichnet, dass sich alle an einander anliegenden Flächen des Trägers (3, 103, 203, 303, 403, 503, 603, 703, 803, 903, 1103, 1203, 1303, 1603) und Gehäuses (23, 123, 223, 423, 525, 623, 723, 823, 923, 1123, 1223, 1235, 1323, 1423, 1523, 1623, 1723) und alle allenfalls sonst noch vorhandenen, zum Befstigen des Gehäuses (623, 723, 823, 923, 1123, 1723) am Träger (603, 703, 803, 903, 1103, 1703) dienenden Befestigungsmittel (629, 755, 855, 857, 955, 959, 1129, 1729) sich vollständig hinter der Ebene befinden, die vom die Schaltvorrichtung (21, 121, 221, 421, 521, 621, 721, 821, 921, 1121, 1221, 1321, 1421, 1521, 1621, 1721, 1821, 1921, 2021) umgebenden Bereich der Träger-Vorderseite (5, 105, 205, 305, 405, 505, 1105, 1205, 1605) aufgespannt wird.

7. Einrichtung nach einem der Ansprüche 1 bis 6, dadurch gekennzeichnet, dass das Gehäuse (23, 423, 523, 623, 1123, 1223, 1323, 1423, 1523, 1623, 1723) mindestens zum Teil durch sich im Inneren des Lochs (11a, 111a, 211a, 411a, 511a, 611a, 1109a, 1211a, 1311a, 1411a, 1511a, 1611a, 1711a) befindende Befestigungsmittel (11b, 23c, 111b, 411b, 423c, 629, 1123c, 1211b, 1223c, 1311b, 1323b, 1423a, 1511b, 1523a, 1611b, 1623a, 1711b) am Träger (3, 403, 503, 603, 1103, 1203, 1303, 1403, 1503, 1603, 1703) befestigt ist.

8. Einrichtung nach einem der Ansprüche 1 bis 7, dadurch gekennzeichnet, dass das Gehäuse (23, 423, 1123, 1223, 1723) ein Aussengewinde (23c, 423c, 1123c, 1223c) aufweist und dass dieses mit einem Innengewinde (11b, 111b, 219, 411b, 1211b) des Lochs (11a, 11a, 211a, 411a, 1109a, 1111a, 1211a, 1711a) des Trägers (3, 103, 203, 403, 1103, 1203, 1703) verschraubt ist, wobei der Träger (3, 103, 203, 303, 403, 1103, 1203, 1703) vorzugsweise mindestens einen im allgemeinen ebenen, mit dem bzw. mindestens einem Loch (11a, 111a, 211a, 411a, 1109, 1111, 1211, 1711) versehenen plattenartigen Teil (11, 111, 211, 411, 1109, 1111, 1211, 1711) aufweist und wobei sich das Innengewinde (11b, 111b, 219, 411b) beispielsweise mindestens teilweise zwischen von der Vorderseite (11c, 111c, 211c) und der Rückseite des bzw. eines plattenartigen Teils (11, 111, 211, 411, 1109, 1211, 1711) aufgespannten Ebenen und/oder mindestens teilweise in einer das Loch (111a, 211a) in zum plattenartigen Teil (111, 211) rechtwinkliger Blickrichtung umschliessenden Verdickung (117, 217) befindet, die über die vom verdickungslosen Bereich der Rückseite des plattenartigen Teils (111, 211) aufgespannte Ebene hinausragt und zum Beispiel durch eine mit dem restlichen, plattenartigen Teil (111) zusammenhängende Ausstülpung oder einen aus einem separaten Werkstück bestehenden, am plattenartigen Teil (211) befestigten Ring gebildet ist.

9. Einrichtung nach einem der Ansprüche 1 bis 7, dadurch gekennzeichnet, dass das Gehäuse (523, 1423) durch eine Press-Verbindung und eventuell zusätzlich durch eine Kleb-Verbindung im Loch (511a, 1411a) des Trägers (503, 1403) befestigt ist.

10. Einrichtung nach einem der Ansprüche 1 bis 7, dadurch gekennzeichnet, dass das Gehäuse (1323, 1523, 1623) im Inneren des Lochs (1311a, 1511a, 1611a) mit dem Träger (1303, 1503, 1603) verrastet und eventuell zusätzlich verklebt ist.

11. Einrichtung nach einem der Ansprüche 1 bis 7, dadurch gekennzeichnet, dass das Gehäuse (623) mittels eines Klebstoffs (629) mit dem Träger (609) verklebt ist, wobei der Klebstoff (629) beispielsweise derart beschaffen ist, dass die Kleb-Verbindung durch Erwärmen auf eine oberhalb der normalen Zimmertemperatur liegende, vorzugsweise mindestens 50° C betragende Temperatur lösbar ist.

12. Einrichtung nach einem der Ansprüche 1 bis 7, dadurch gekennzeichnet, dass die Schaltvorrichtung (721, 821, 921) mittels Schrauben (755, 855, 955) und/oder Gewindebolzen lösbar am Träger (703, 803, 903) befestigt ist, wobei die Schrauben (755, 855, 955) bzw. Gewindebolzen beispielsweise je ein Loch (723k) des Gehäuses (723) oder eines am Gehäuse (823, 923) angreifenden Halters (857, 957) durchdringen, der bei spielsweise ausschliesslich zur Befestigung einer Schaltvorrichtung (821) oder beispielsweise zusätzlich als Platte einer gedruckten Schaltung (959) dient.

13. Einrichtung nach einem der Ansprüche 1 bis 12, dadurch gekennzeichnet, dass der Träger (3, 103, 203, 303, 403, 505, 603, 703, 803, 903, 1103, 1203, 1303, 1403, 1503) mindestens einen plattenartigen Teil (11, 111, 211, 411, 511, 611, 711, 811, 911, 1109, 1111, 1211, 1311, 1411, 1511) aufweist, dass das Loch (11a, 411a, 511a, 611a, 711a, 811a, 1109a, 111a, 1211a, 1311a, 1411a, 1511a) - und vorzugsweise jedes von mehreren solchen - den plattenartigen Teil (11, 411, 511, 611, 711, 811, 911, 1109, 1211, 1311, 1411, 1511) durchdringt, dass das bzw. jedes Gehäuse (23, 423, 523, 623, 723, 823, 923, 1123, 1223, 1323, 1423, 1523) mindestens ungefähr bündig mit der Vorderseite (11c, 111c) des plattenartigen Teils (11, 111, 211, 411, 511, 611, 711, 811, 911, 1109, 1111, 1211, 1311, 1411, 1511) ist und/oder über diese Vorderseite (411c, 511c) hinausragt, dass an der Vorderseite (11c, 411c, 511c, 1111c) des plattenartigen Teils (11, 411, 511, 611, 711, 811, 911, 1211, 1311, 1411, 1511) bzw. des vordersten, plattenartigen Teils (1111) eine Folie (13, 413, 513, 613, 713, 813, 1113, 1213, 1313, 1413, 1513) befestigt ist, die die Betätigungswand (23e, 423e, 523e, 623e, 723e, 1123e, 1223e) des bzw. jedes Gehäuses (23, 423, 523, 623, 723, 823, 923, 1123, 1223, 1323, 1423, 1523) sowie mindestens den diese umgebenden Bereich des plattenartigen Teils (11, 411, 511, 611, 711, 811, 911, 1111, 1211, 1311, 1411, 1511) überdeckt und zum Tragen einer sich vor der bzw. jeder bedeckten Betätigungswand (23e, 423e, 523e, 623e, 723e, 1123e, 1223e) befindenden, optisch erkennbaren, ein Betätigungs- und/oder Tastfeld (15, 315, 415, 515, 615) definierenden Markierung dient, wobei eventuell das bzw. mindestens ein Feld (415, 515) von einer Erhöhung (413h, 513h) der Folie (413, 513) umschlossen ist, welche Erhöhung (413h, 513h) durch eine axial vorstehende Erhöhung (423h) der Betätigungswand (423e) so wie eine dadurch bewirkte Verformung der Folie (413) oder durch eine Verdikkung (513h) der Folie (513) selbst gebildet ist und/oder wobei eventuell die vordere Oberfläche der Folie (613) im Bereich des bzw. mindestens eines Feldes (615) glatter ist als in dessen Umgebung.

14. Einrichtung nach einem der Ansprüche 1 bis 12, dadurch gekennzeichnet, dass der Träger (1603) einen plattenartigen Teil (1611) aufweist und dass das Loch (1611a) - und vorzugsweise jedes von mehreren solchen - durch ein Sackloch des plattenartigen Teils (1611) gebildet und auf dessen Vorderseite durch einen folienartigen Abschnitt (1611c) begrenzt ist, der mit dem restlichen plattenartigen Teil (1611) zusammenhängt.

15. Einrichtung nach einem der Ansprüche 1 bis 12, dadurch gekennzeichnet, dass der Träger (1703) mindestens einen plattenartigen Teil (1711) aufweist, dass das Loch (1711a) - und vorzugsweise jedes von mehreren solchen - den plattenartigen Teil (1711) durchdringt, und dass auf die Betätigungswand des bzw. jedes Gehäuses (1723) eine zum Tragen einer Markierung dienende Folie (1713) befestigt, beispielsweise aufgeklebt ist, deren Umriss-Abmessungen kleiner als diejenigen des in die Vorderseite des plattenartigen Teils (1711) mündenden Abschnitts (1711c) des Lochs (1711a) sind und die sich vorzugsweise im Innern des Lochs (1711a) befindet und beispielsweise mindestens ungefähr bündig mit der Vorderseite des plattenartigen Teils (1711) ist.

16. Einrichtung nach einem der Ansprüche 1 bis 15, gekennzeichnet durch das Gehäuse (23, 523, 623, 1223) umschliessende, an der Rückseite des Trägers (23) und/oder im Loch angeordnete, die Verbindung des Gehäuses (23, 523, 623, 1223) mit dem Träger (3, 103, 503, 605, 1203) zumindest wasserdicht und vorzugsweise wasserdampf- sowie gasdicht abschliessende Dichtungsmittel (29, 529, 629), die zum Beispiel einen Dichtungsring (29, 529) und/oder einen auch zur Befestigung des Gehäuses (623) am Träger (603) dienenden Klebstoff (629) aufweisen.

17. Elektrische Schaltvorrichtung für eine Einrichtung nach einem der Ansprüche 1 bis 16.

18. Schaltvorrichtung nach Anspruch 17, dadurch gekennzeichnet, dass das Gehäuse (23, 1123) nur ein einziges piezoelektrisches Element (31, 1131) enthält, dass mindestens ein aus dem Innenraum (27) des Gehäuses (23, 1123) herausgeführter, elektrischer Anschluss (45, 1145) vorhanden ist, dass der bzw. jeder Anschluss (45, 1145) auf der der Betätigungswand (23e, 1123e) abgewandten Seite des piezoelektrischen Elements (31, 1131) aus dem Gehäuse (23, 1123) herausgeführt ist und vorzugsweise einen länglichen flexiblen Leiter aufweist, der zwischen seinen beiden Enden beispielsweise mit einer am Gehäuse (23, 1217) befestigten Zugentlastungsvorrichtung (51, 1151) gegen ein Herausreissen aus dem Gehäuse (23, 1123) gesichert ist, wobei das Gehäuse (23, 1123) vorzugsweise einen hülsenförmigen, einstückigen, das piezoelektrische Element (31, 1131) enthaltenden, die Betätigungswand (23e, 1123e) und beispielsweise auch einen Mantel bildenden, bei seiner der Betätigungswand (23e, 1123e) abgewandten Stirnseite wandlosen Körper aufweist, dessen Innenraum beim der Betätigungswand (23e, 1123e) abgewandten Ende vorzugsweise mit zum Beispiel eine Vergussmasse (47) aufweisenden Mitteln (47, 51, 1147, 1151) abgeschlossen ist.

19. Schaltvorrichtung nach Anspruch 17 oder 18, dadurch gekennzeichnet, dass im Innenraum des Gehäuses (23) elektronische, elektrisch mit dem piezoelektrischen Element (31, 1131, 1831, 1931, 2031 verbundene Schaltungsmittel (41, 1141, 1143, 1841, 1939, 2039) angeordnet und zwei mit diesen verbundene Anschlüsse (45, 1145, 1845, 1945, 2045), vorhanden sind, dass die Schaltungsmittel (41, 1141, 1143, 1841, 1939, 2039) mindestens ein elektrisch steuerbares, mit den beiden Anschlüs sen (45, 1145, 1845, 2045) verbundenes, elektrisch steuerbares Schaltorgan (1873) aufweisen und ausgebildet sind, um den Schaltzustand des Schaltorgans (1873, 2073) beim Ausüben einer Druckkraft auf das piezoelektrische Element (31, 1131, 1831, 1931, 2031) zumindest vorübergehend zu ändern und eine elektrische Verbindung zwischen den beiden Anschlüssen (45, 1145, 1845, 1945, 2045) zu bilden oder zu unterbrechen.

20. Schaltvorrichtung nach Anspruch 19, dadurch gekennzeichnet, dass die Schaltungsmittel (41, 1141, 1143, 1839) derart ausgebildet sind, dass sie für ihren Betrieb ausser einer an die genannten Anschlüsse (45, 1145, 1845, 1945) angelegten elektrischen Spannung keine andere elektrische Spannung benötigen.

Fig. 1

Fig. 4

Fig. 2

Fig. 3

Fig. 5

Fig. 6

Fig. 7

Fig. 8

Fig. 9

Fig. 10

Fig. 11

Fig. 12

Fig. 13

Fig. 14

## Fig. 15

1101 1111 1105 1113 1123a 1111c 1117
1115  1111a
1107
1129
1121
1123
1145  1125 1153
1103
1129f

## Fig. 16

1135b 1123e 1135a 1131 1127a
1149
1123c
1109a
1135
1141
1109
1123c
1121
1123
1147
1151
1145  1125 1153b 1153a
1127
1143
1153

## Fig. 17

1201 1211e 1205 1223e 1213 1211c 1211
1227a  1211d
1211a
1235  1211b
1207
1221
1223  1225  1245
1223b
1235b
1223f
1203
1223c
1227
1223a

## Fig. 18

1323 1323b 1313 1311
1303 1321 1345 1311b 1311a

## Fig. 19

1413 1423a 1411
1403 1421 1423 1411a

## Fig. 20

1513 1511b 1511
1503 1511a 1521 1523 1523a

## Fig. 21

1611 1611c 1611b
1623a
1603 1621 1623 1611a

## Fig. 22

## Fig. 23

## Fig. 24

## Fig. 25